(19) Europäisches Patentamt
European Patent Office
Office européen des brevets

(11) **EP 2 421 147 B1**

(12) **EUROPÄISCHE PATENTSCHRIFT**

(45) Veröffentlichungstag und Bekanntmachung des Hinweises auf die Patenterteilung:
**11.02.2015 Patentblatt 2015/07**

(51) Int Cl.:
*H02P 21/14* *(2006.01)*    *H02P 23/14* *(2006.01)*
*G01R 31/34* *(2006.01)*

(21) Anmeldenummer: **10172910.1**

(22) Anmeldetag: **16.08.2010**

(54) **Vorrichtung und Verfahren zur drehgeberlosen Identifikation elektrischer Ersatzschaltbildparameter eines Drehstrom-Synchronmotors**

Device and method for identifying equivalent circuit parameters of an alternating current synchronous motor without using a rotary encoder

Dispositif et procédé d'identification des paramètres d'un schéma électrique équivalent d'un moteur synchrone triphasé sans utilisation d'encodeur de vitesse

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**22.02.2012 Patentblatt 2012/08**

(73) Patentinhaber: **Baumüller Nürnberg GmbH**
**90482 Nürnberg (DE)**

(72) Erfinder:
• **Villwock, Sebastian**
**95701 Pechbrunn (DE)**
• **Zatocil, Heiko**
**90429, Nürnberg (DE)**

(74) Vertreter: **Götz, Georg Alois**
**Intellectual Property IP-GÖTZ**
**Patent- und Rechtsanwälte**
**Postfach 35 45**
**90017 Nürnberg (DE)**

(56) Entgegenhaltungen:
**JP-A- 2000 032 800     US-A1- 2010 060 210**

• **VERMEULEN H J ET AL: "Off-line identification of an open-loop automatic voltage regulator using pseudo-random binary sequence perturbations", AFRICON, 1999 IEEE CAPE TOWN, SOUTH AFRICA 28 SEPT.-1 OCT. 1999, PISCATAWAY, NJ, USA,IEEE, US LNKD- DOI: 10.1109/AFRCON.1999.821870, Bd. 2, 28. September 1999 (1999-09-28), Seiten 799-802, XP010367338, ISBN: 978-0-7803-5546-0**
• **VILLWOCK S ET AL: "Influence of the power density spectrum of the excitation signal on the identification of drives", INDUSTRIAL ELECTRONICS, 2008. IECON 2008. 34TH ANNUAL CONFERENCE OF IEEE, IEEE, PISCATAWAY, NJ, USA, 10. November 2008 (2008-11-10), Seiten 1252-1257, XP031410622, ISBN: 978-1-4244-1767-4**
• **VILLWOCK S ET AL: "Application of the welch-method for the automatic parameter identification of electrical drives", INDUSTRIAL ELECTRONICS SOCIETY, 2005. IECON 2005. 31ST ANNUAL CONFERENCE OF IEEE, IEEE, PISCATAWAY, NJ, USA LNKD- DOI: 10.1109/IECON.2005.1569118, 6. November 2005 (2005-11-06), Seiten 1449-1454, XP010876187, ISBN: 978-0-7803-9252-6**

**Beschreibung**

Die vorliegende Erfindung geht aus von einem Verfahren, einer Einrichtung, einer Vorrichtung und einer Verfahrensverwendung für eine drehgeberlose Identifikation elektrischer Ersatzschaltbildparameter eines Drehstrom-Synchronmotors. Elektrische Ersatzschaltbildparameter ermöglichen die Charakterisierung eines Drehstrommotors mittels elektrischer Ersatzschaltbildkomponenten, so dass das elektrische Verhalten des Motors im Betrieb nachgebildet werden kann.

STAND DER TECHNIK

Aus dem Stand der Technik, z.B. aus der JP 2000 032800 A oder der US 2010/0060210 A1, sind verschiedene Methoden bekannt, um das elektrische Verhalten eines Drehstrommotors zu bestimmen. In der Regel werden Gleichstrom- und Kurzschlussversuche an einem Motor vorgenommen, um das elektrische Verhalten in derartigen Betriebsszenarien zu messen und daraus das elektrische Betriebsverhalten für andere Betriebsfälle ableiten zu können. Ein Drehstrom-Synchronmotor umfasst einen Stator mit mindestens drei Statorspulen und einen Rotor mit einer Permanentmagnetisierung, die entweder durch Permanentmagnete hervorgerufen wird, oder durch mit Gleichstrom durchflossenen Spulen, die bürstenversorgt sind, erzeugt wird. Typischerweise verwendet man zur Charakterisierung des elektrischen Verhaltens eines Synchronmotors ein sogenanntes Ersatzschaltbild, bei dem die Statorspule mittels eines ohmschen Widerstands $R_1$ und einer Induktivität $L_1$ sowie einer Spannungsquelle $U$p zur Berücksichtigung der gegeninduzierten Spannung nachgebildet wird. Mittels Gleichstrom- und Kurzschlussversuchen wird typischerweise versucht, die Größe der konzentrierten Bauteilparameter des Ersatzschaltbilds für Drehstrommotoren zu bestimmen. Die vorgenannten Versuche stellen Zeitbereichsverfahren dar, bei dem sich der Motor bewegt, und die einen Antrieb des Motors in einer Testumgebung erfordern. Beim Kurzschlussversuch muss der Motor festgestellt werden, wobei sich die Gefahr einer Überlastung ergeben kann. Bei einem Gleichstromversuch kann der ohmsche Statorwiderstand $R_1$ bestimmt werden, wobei sich die Gefahr elektrischer Überlastung ergeben kann. Aus dem Kurzschlußversuch kann auf die Induktivität $L_1$ rückgeschlossen werden.

Die vorgenannten Kurzschluss- und Gleichstromversuche berücksichtigen in vielen Fällen Messergebnisse mechanischer Sensoren, wie beispielsweise Positionssensoren, Winkel- oder Drehzahlsensoren, um eine Korrelation des Betriebsverhaltens des Motors bei verschiedenen Umdrehungszahlen herleiten zu können.

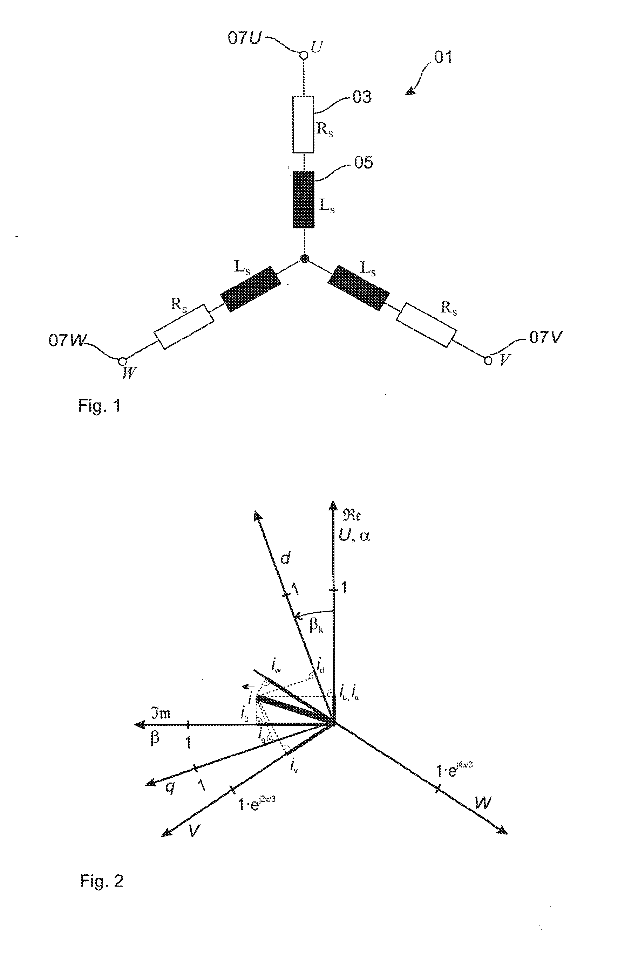

In einem Dreiphasensystem ergibt sich in Y- oder Δ-Schaltung durch Einspeisung zweier Phasen jeweils der Strom der dritten Phase nach der *Regel* $I_u + I_v + I_w = 0$ bei fehlender Sternpunkterdung. Aus diesem Grund lässt sich ein Dreiphasensystem auch mittels zweier Koordinaten beschreiben, wobei zur Beschreibung des Gesamtstroms ein Koordinatensystem in der komplexen Ebene betrachtet werden kann, bei der die beiden Koordinaten Realteil und Imaginärteil als α- und β-Koordinaten bezüglich der ortsfesten Ausrichtung der Statorwicklungen nach Fig. 1 bezeichnet werden können. Das a/β-Koordinatensystem beschreibt beispielsweise die Richtung des Stromflusses oder die Rotorflußachse in dem ruhenden Bezugssystems des Stators des Drehstrommotors. Bezüglich der magnetischen Ausrichtung des Läufers kann ein zweites sich drehendes Koordinatensystem eingeführt werden, dessen Achsen als d- und q-Achse des Rotors bezeichnet werden, wie es in Fig. 2 dargestellt ist. Die d-Achse bezeichnet die Richtung des Läuferflusses und die q-Achse die hierzu rechtwinklige Querflussachse. Eine Transformation von a/β-Statorkoordinatensystem in das sich drehende d/q-Rotorkoordinatensystem kann über den Drehwinkel $\beta_k$ zwischen der Wicklungsachse der Phase U des Stators und der Längsachse des Rotormagnetfeldes hergestellt werden. Diesbezüglich können ein Gesamtmotorstrom $I$, bzw. dessen drei Phasenströme $I_U$, $I_V$ und $I_W$ im statorfesten a/β-Koordinatensystem oder im sich mit dem Läufer drehenden d/q-Koordinatensystem betrachtet werden. Bezüglich der Umrechnung der Strangströme des Drehstrom-Synchronmotors in das a/β-Koordinatensystem gilt folgender Zusammenhang:

$$\begin{pmatrix} i_\alpha \\ i_\beta \end{pmatrix} = \begin{pmatrix} 1 & 0 & 0 \\ 0 & \dfrac{\sqrt{3}}{3} & -\dfrac{\sqrt{3}}{3} \end{pmatrix} \begin{pmatrix} i_u \\ i_v \\ i_w \end{pmatrix}, \qquad \begin{pmatrix} i_u \\ i_v \\ i_w \end{pmatrix} = \begin{pmatrix} 1 & 0 \\ -\dfrac{1}{2} & \dfrac{\sqrt{3}}{2} \\ -\dfrac{1}{2} & -\dfrac{\sqrt{3}}{2} \end{pmatrix} \begin{pmatrix} i_\alpha \\ i_\beta \end{pmatrix},$$

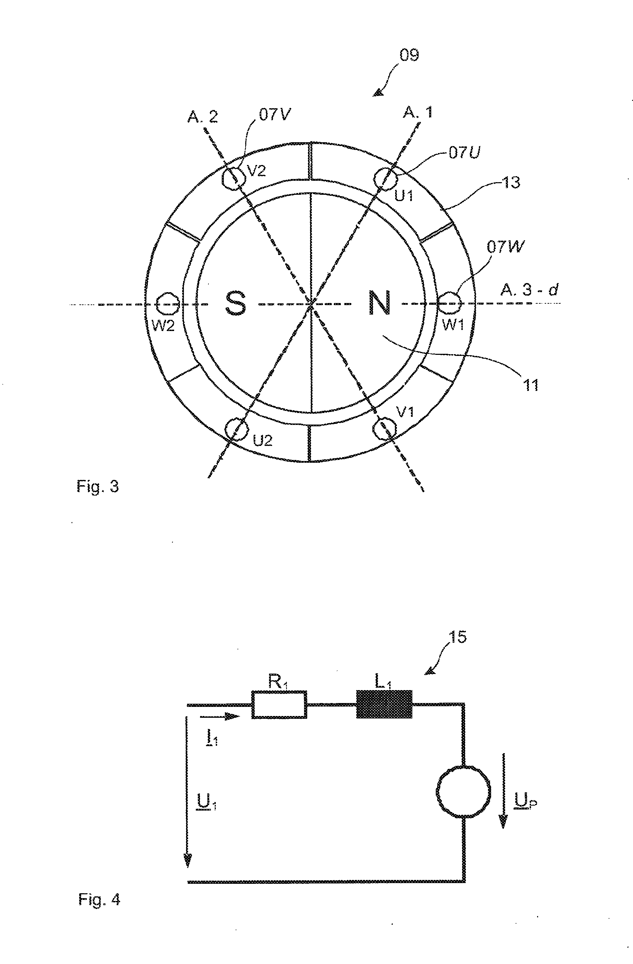

der mittels Berücksichtigung des Läuferflußwinkels $\beta_k$ gegenüber dem Stator für das d/q-Koordinatensystem modifizierbar ist. Zur nachfolgenden mathematischen Erfassung der Zusammenhänge wird eine Betrachtung im α/β-Statorkoordinatensystem nach Fig. 2 durchgeführt, wobei das in Fig. 4 dargestellte Ersatzschaltbild, eine Ersatzschaltbildcharakterisierung der Drehstrom-Synchronmaschine in einem einphasigen System mit Speisespannungen- und Ströme $U_1$, $I_1$ sowie $U_2$/ $I_2$ beschreibt.

In der Fig. 4 ist das Ersatzschaltbild eines Synchronmotors im Stillstand (n=0) bezüglich eines $\alpha/\beta$-Zeigerdiagramm ohne Reluktanzeinflüsse dargestellt, wobei unter Kenntnis der genannten Ersatzschaltbildgrößen das elektrische Betriebserhalten des Drehstrommotors in verschiedenen Betriebsfällen abschätzbar wird:

$$U_{1\alpha} = R_1\,I_{1\alpha} + L_1\frac{dI_{1\alpha}}{dt}$$

$$U_{1\beta} = R_1\,I_{1\beta} + L_1\frac{dI_{1\beta}}{dt}$$

Die beiden Differentialgleichungen stellen im Frequenzbereich ein PT1-Verhalten dar. Hieraus lässt sich die Admittanz des Motors im Betriebsverhalten bestimmen, die sich nach folgender Gleichung ergibt:

$$G = \underline{Y} = \frac{1}{R_1 + sL_1} = \frac{1}{b_0 + sb_1}$$

Die oben genannte Admittanz als Übertragungsfunktion G $=\underline{Y}= I_{1d}/U_{1d}$ wird unter der Annahme einer Drehzahl $n$=0 hergeleitet, da sich hierbei keine Gegenspannung in den Statorspulen ergibt und der Term $U_\mathrm{P}$ vernachlässigt werden kann.

Ausgehend von den Phasenspannungen $U_u$, $U_\mathrm{V}$ und $U_\mathrm{W}$ und Strangströmen $I_\mathrm{U}$, $I_\mathrm{V}$ und $I_\mathrm{W}$ werden diese gemäß der obigen Transformation in das d/q-Koordinatensystem überführt. Somit lässt sich das elektrische Verhalten der Drehstrom-Synchronmaschine mit Hilfe der Eingangsgröße $U_1$ und Ausgangsgröße $I_1$ betrachten. Diesbezüglich lassen sich getrennte Betrachtungsweisen bezüglich der $d$- und $q$-Koordinate durchführen, so dass sich die Übertragungsfunktion, beziehungsweise Admittanz ergibt:

$$G_1 = I_{1d}/U_{1d}.$$

Durch Bestimmung der Übertragungsfunktion $G_1$ können die unbekannten Koeffizienten der Übertragungsfunktion bestimmt werden.

Aus dem Stand der Technik, z.B. aus "Villwock, S. et al.: ,Influence of the Power Density Spectrum of the Excitation Signal on the Identification of Drives', INDUSTRIAL ELECTRONICS, 2008. IECON 2008. 34TH ANNUAL CONFERENCE OF IEEE, IEEE, PISCATAWAY, NJ, USA, 10. November 2008 (2008-11-10), Seiten 1252-1257, XP031410622ISBN: 978-1-4244-1767-4), ist zur Bestimmung mechanischer Kenngrößen eines Drehstrommotors, insbesondere zur Fehlerdiagnose mechanischer Teile oder zur mechanischen Systemidentifikation beim Betrieb in einem mechanischen Verband bekannt, ein Pseudo-Rausch-Binär-Signals (PRBS) als elektrische Testanregung einzusetzen. Eine Verwendung von PRBS ist auch aus "Vermeulen, H.J. et al.: ,Off-lline identification of an open-loop automatic voltage regulator using pseudo-random binary sequence perturbations", AFRICON, 1999 IEEE CAPE TOWN, SOUTH AFRICA 28 Sept. - 1 OCT. 1999, PISCATAWAY, NJ, USA, IEEE, US LNKD-DOI: 10.1109/AFRCON. 1999.821870, Bd. 2, 28. September 1999 (1999-09-28), Seiten 799-802, XP010367338ISBN: 978-0-7803-5546-0" bekannt. Dabei stellt das mechanische System ein SISO-System (Single-Input Single-Output) dar, bei der mit Hilfe einer einzigen mechanischen oder elektrischen Eingangsgröße eine einzige mechanische Ausgangsgröße gemessen werden kann. Die Eingangsgröße wird mit Hilfe des Pseudo-Rausch-Binär-Signals angeregt, so dass in der Ausgangsgröße ein breitbandiges Verhalten des SISO-Systems bestimmt werden kann. Mit Hilfe signaltheoretischer Methoden der Frequenztransformation und Parameteridentifikation anhand des Frequenzverhaltens können Kenngrößen des mechanischen Systems bei Kenntnis der zugrundeliegenden Systemgleichung abgeleitet werden.

Im Falle elektrischer Kenngrößen handelt es sich allerdings um ein sogenanntes MIMO-System (Multiple-Input Multiple-Output), bei dem mehrere Eingangsgrößen (Strangspannungen) eingespeist und mehrere Ausgangsgrößen (Strangströme) extrahiert werden müssen. Aus diesem Grund können die aus dem Verfahren zur Identifikation mechanischer Größen bekannten Methoden nicht für die elektrische Systemcharakterisierung eines Drehstrommotors angewendet werden. Die Identifikation des mechanischen Systems ist umfassend in der Dissertation von Sebastian Villwock "Identifikationsmethoden für die automatisierte Inbetriebnahme und Zustandsüberwachung elektrischer Antriebe", Universität Siegen, 2007, (Druckschrift [1]) beschrieben. Des Weiteren ist eine diesbezüglich verwendete signaltheoretische Methode für die Parameteridentifikation eines mechanischen Systems in dem Zeitschriftenbeitrag: S. Villwock, J. M. Pacas: " Application of the Welch-Method for the Identification of Two and Three Mass Systems", IEEE Transactions on Industrial Electronics, Vol. 55, No. 1, Januar 2008, S. 457-466 (Druckschrift [2]) beschrieben. Ein gattungsähnliches Verfahren ist im Rahmen eines Konferenzartikels in: P. Szczupak, J. M. Pacas: "Automatic Identification of a PMSM Drive Equipped with an Output LC-Filter", IEEE Industrial Electronics, IECON 2006, 32nd Annual Conference on November 2006, S. 1143-1148 (Druckschrift [3]) vorgestellt.

Aufgabe der vorliegenden Erfindung ist es, ausgehend von einem elektrischen Ersatzschaltbild einer Drehstrom-Synchronmaschine ein Verfahren zur Bestimmung der Ersatzschaltbildkenngrößen vorzuschlagen, wobei eine Parameteridentifikation ohne elektrische oder mechanische Belastung des Motors ermöglicht wird, der Rotor stillsteht und durch eine einzige Messung alle elektrischen Ersatzschaltbildparameter für eine Beschreibung des elektrischen Verhaltens des Drehstrommotors für einen großen Frequenzbereich ermittelt werden kann. Vorteilhafte Fortbildungen der Erfindung sind Gegenstand der Unteransprüche.

OFFENBARUNG DER ERFINDUNG

In einem ersten Aspekt der Erfindung wird ein Verfahren nach Anspruch 1 vorgeschlagen.

Eine Stillstandslage des Rotors bedeutet, dass sich der Winkel des Rotors gegenüber dem Stator nicht ändert, und somit der Drehwinkel zwischen $\alpha$- und $d$-Achse konstant und gegebenenfalls bekannt ist. Nach Einnahme einer Stillstandslage des Rotors wird eine Testsignalspannung in die d-Flussachsenriehtung des Rotors eingespeist und der sich ergebende Meßsignalstrom gemessen. Eine Stromeinprägung in $d$-Achsennchtung bewirkt eine Ausrichtung des Rotors, wobei kein Drehmoment auf den Rotor ausgeübt wird. Die Struktur des Testsignals bestimmt, welche Frequenzkomponenten oder - bereiche messbar sind und mit welcher Genauigkeit die Ersatzschaltbildpameter identifiziert werden können, wobei Parameter entsprechend der Frequenzabdeckung des Testsignals extrahiert werden können, Eine Einspeisung der Testspannung $U_{1d}$ erzeugt einen Meßsignalstrom $I_{1d}$. der ermittelt werden kann.

Im Gegensatz zu einem Asynchronmotor würde es bei einer identischen Einspeisung eines Testsignals in beide Rotorachsrichtungen d und q zur Drehmomentbildung und somit zu einer mechanischen Bewegung der Motorwelle kommen. Um diese zu vermeiden kann zunächst eine Rastlagesuche durchgeführt werden, damit die Lage der d-Flussachse bekannt ist. Im Unterschied zur Asynchronmaschine erfolgt anschließend die Frequenzgangmessung durch Einspeisung des Testsignals ausschließlich in $d$-Richtung, da die d-Komponente des Statorstroms $I_{1d}$ nicht zur Drehmomentbildung beiträgt. Die Rastlagesuche kann in einem ersten Schritt vermieden werden, indem die Bestromung der Maschine in $\alpha$-Richtung mit einem Gleichstrom erfolgt. Dann richtet sich der Rotor an der $\alpha$-Achse aus, so dass $\alpha$- und d-Achse Übereinstimmen. Somit kann das Testsignal in einem zweiten Schritt über die $\alpha$-Achse, die jetzt mit der $d$-Achse übereinstimmt, in den Drehstrommotor eingespeist werden. Im Ergebnis erfolgt die Selbstidentifikation momentenfrei, und die Motorwelle führt keine mechanische Bewegung. Alternativ kann, falls die Rastlage alias Pollage der Synchronmaschine a priori bekannt ist, das Testsignal auch direkt als Spannung $U_{1d}$ geeignet in die Statorwicklungen eingespeist werden.

Die Einspeisung der Strangspannung kann beispielsweise mittels eines 2/3-Phasen-Konverters erfolgen, der obiger Matrixrelation folgend und unter Beachtung des Rotordrehwinkels $\beta_k$ aus den beiden Spannungen $U_{1d}$ und $U_{1q}$ die drei Phasenspannungen $U_U$, $U_V$ und $U_W$ erzeugen bzw. aus den drei gemessenen Strömen $I_U$, $I_V$ und $I_W$ die beiden Ströme $I_{1d}$ und $I_{1q}$ transformieren kann. Eine Einspeisung des Testsignals kann beispielsweise durch eine Steuerung eines Wechselrichters der Motorsteuerungsvorrichtung des Drehstrommotors erfolgen. Alternativ kann die Testsignalspannung unter Umgehung des Motorsteuerungs-Wechselrichter direkt in die Stränge der Synchronmaschine entsprechend der Lage der d-Achse eingespeist werden. Die Messung der Strangströme kann über die selben Strommessinstrumente erfolgen, die bei einer drehgeberlosen Regelung im Betrieb des Drehstrommotors verwendet werden. Im Zeitbereich können die eingespeisten Testsignalspannungen und die gemessenen Meßsignalströme als digital erfasste zeitliche Abtastwerte aufgezeichnet werden, und auf deren Basis können die Ersatzschaltbildparameter extrahiert werden. Dies erfolgt bevorzugt durch eine Frequenzbereichsanalyse, d.h. einer Frequenztransformation der aufgezeichneten Zeitbereichsdaten, und einer Analyse des Frequenzgangs der gemessenen Übertragungsfunktion $G_1$. Unter Kenntnis der vorgenannten Admittanzfunktion, die als Übertragungsfunktion im Frequenzbereich dargestellt werden kann, können die Parameter der Übertragungsfunktion mittels einer geeigneten signaltheoretischen Methode ermittelt werden, wobei diese Parameter zur Identifikation der Ersatzschaltbildkenngrößen $R_1$ und $L_1$ herangezogen werden können.

Während der Einspeisung des Testsignals in die d- Rotorkoordinatenrichtung wird kein Drehmoment in der Maschine erzeugt, so dass der Rotor drehmomentfrei und in seiner Lage verbleibt. Hierdurch kann eine Messung im Stillstand des Motors vorgenommen werden, wobei keine Sensordaten berücksichtigt werden müssen und selbst die Parameter eines Motors im eingebauten Zustand innerhalb eines mechanischen Antriebsstrangs nachträglich die Ersatzschaltbildparameter extrahiert werden können, ohne dass die Art des Antriebsstrangs Einfluss auf die Messergebnisse hat. Hierzu kann es vorteilhaft denkbar sein, die Höhe der Testsignalspannung $U_{1d}$ zu variieren und jeweils Parameteridentifikationen mit geänderten Spannungswerten durchzuführen, wobei die sich ergebenden Parameter als Durchschnitt oder gewichteter Parameter aus den Ergebnissen der einzelnen Parameteridentifikationen ermittelbar sein können. Somit können Fehler in der Bestimmung vermindert werden, so dass ein genaueres Ergebnis erzielt werden kann.

Eine Bestimmung des Frequenzgangs der Übertragungsfunktion G unter Kenntnis der zugrunde liegenden Admittanz-Formel $\underline{Y}$ ermöglicht die Extraktion der Ersatzschaltbildparameter. Somit kann durch eine Einspeisung eines insbesondere breitbandigen Testsignals mittels einer einzigen Messung Aussagen über die Ersatzschaltbildkenngrößen des Drehstrommotors getroffen werden. Hierzu werden signaltheoretische Methoden herangezogen, die die gemessenen Zeitbereichsdaten in Frequenzbereichsdaten transformieren, wobei der Frequenzgang formelmäßig erfasst werden kann, und mittels einer Parameterextraktion aus dem Frequenzgang die Parameter der zugrundeliegenden Übertragungsfunktion und damit die Ersatzschaltbildgrößen identifiziert werden können.

Grundsätzlich kann statt einer Testspannungsvorgabe und Meßstrombestimmung auch eine Teststromvorgabe mit Meßspannungserfassung erfolgen. Allerdings weisen insbesondere leistungsstarke Motoren ein hochinduktives Verhalten auf, so daß zur Einprägung rechteckförmiger Stromschaltimpulse hohe Treiberspannungen angelegt werden müßten, worduch eine Teststromeinprägung nur mit hohem Aufwand möglich ist.

Gemäß einer vorteilhaften Weiterbildung der Erfindung kann die Stillstandslage eine Rastlage, d.h. Polradlage des Rotors sein, bei der d-Flussachsenrichtung des Rotors mit $\alpha$-Achsrichtung des Stators übereinstimmt, oder eine vorbekannte Rotorlage oder eine erzwungene Stillstandszwangslage durch Konstantbestromung des Synchronmotors in eine $\alpha$-Achsenrichtung ein. Stimmen d-Flussachsenrichtung des Rotors mit $\alpha$-Achsrichtung des Stators überein, so beträgt der Rotorlagenwinkel $\beta_k=0$, d.h. es wird ein definierter Polradwinkel eingenomen. Eine Bestromung in $\alpha$ -Achsrichtung bewirkt somit eine Ausrichtung der d-Flussachsenrichtung, wobei der Rotor drehmomentfrei bleibt. Ist eine Rotorlage bekannt, beispielsweise durch einen definierten mechanischen Anschlag oder eine Lageinformation durch einen Drehwinkelsensor, so kann eine Bestromung der Statorwicklungen in Lagerichtung der d-Rotorachse erfolgen. Auch kann eine Konstantbestromung der Statorspulen in einer beliebigen Lage eine Ausrichtung der d-Achse in die Achse des sich einstellenden Statormagnetfelds erzwingen. Eine Rastlagenausrichtung hat den Vorteil, dass selbst nach Beendigung einer Konstantbestromung der Rotor in dieser Lage festgestellt verharrt so dass genügend kleine Testsignalspannungen, die selbst einen geringen q-Achsenanteil aufweisen können, keine ungewollte Drehbewegung des Rotors aus der Rastlage heraus bewirken kennen. Ein Verfahren zur Rastlagensuche ist in vielen aus dem Stand der Technik bekannten Motorsteuerungsvorrichiungen bereits implementiert

Gemäß einer vorteilhaften Weiterbildung kann das Testsignal ein Pseudo-Rausch-Binär-Signal sein. Das Testsignal sollte eine hohe Bandbreite aufweisen, um eine möglichst hohe Frequenzauflösung des elektrischen Motorverhaltens zu ermöglichen, Weißes Rauschen besitzt ein gleichverleiltes breitbandiges Frequenzspektrum. Ein Pseudo-Rausch-Binär-Signal (PRBS) ist ein binäres Signal, welches das Spektrum von weißem Rauschen approximiert. Es kann typischerweise die Werte +1 und -1 annehmen und wird alternativ zum weißen Rauschen verwende. Vorteilhaft ist insbesondere die Reproduzierbarkeit des Signals, wobei häufig in der Regelungstechnik ein PR8-Signal zur Analyse eine Impulsantwort mittels einer Maximum-Length-Sequence verwendet wird. Ein PRB-Testsignal lässt sich leicht durch linear rückgekoppelte Schieberegister erzeugen und kann beispielsweise durch einen DSP (Digital Signal Processor), FPGA (Field Programmable Gate Array) oder Mikrocontroller eines Motorreglers zur Ansteuerung des Wechselrichters erzeugt werden. Somit kann jede Motoransteuereiektronik solch ein PRB-Signal ohne größere Modifikation erzeugen und als Motorspannung in den Motor einspeisen.

Grundsätzlich kann eine Frequenzbereichstransformation von abgetasteten Zeitbereichsdaten zur Identifikation der Ersatzschaltbildparameter im Frequenzbereich beliebig erfolgen. Gemäß einer vorteilhaften Weiterbildung der Erfindung kann die Identifikation der Ersatzschaltbildparameter eine Fouriertransformation nach einem Periodogramm-Verfahren, bevorzugt ein Bartlett-Vertahren, insbesondere einem Welch-Verfahren umfassen. Im Rahmen eines Periodogramm-Verfahrens wird eine spektrale Leistungsdichte durch eine Fourier-Transformation einzelner Datenblöcke erreicht. Die Qualität der Spektralschätzung kann verbessert werden, indem eine Anzahl voneinander unabhängiger Periodogramme gemittelt wird. Dieses Verfahren ist in der Literatur unter dem Namen Bartlett-Methode bekannt, bei dem das gemessene Signal in Abschnitte aufgeteilt wird, Die Welch-Methode stellt eine Erweiterung der von Bartlett vorgeschlagenen Vorgehensweise dar. Zur Reduzierung des Leck-Effekts (engl, Leakage-effect) kommen hier bestimmte Fensterfunktionen zum Einsatz. Der störende Leck-Effekt tritt dann auf, wenn der Signalabschnitt nicht periodisch, ein ganzzahliges Vielfaches der Periode oder dieser Signalabschnitt an den Rändern von null verschieden ist. Die Anwendung eines Welch-Verfahrens bei der Identifikation eines Zwei- oder Dreimassensystems ist bereits aus der oben genannten Druckschrift [2] bekannt. Das Welch-Verfahren spaltet M-Abtastwerte in K-Teilfolgen auf, die mit einer Fensterfunktion gewichtet werden, und auf die eine Fouriertransformation angewendet wird, Die in der Druckschrift [1] beschriebene Welch-Methode ermöglicht die Transformation einer beliebigen Zahl von Abtastwerten mit einer möglichst hohen Genauigkeit in den Frequenzbereich.Hierbei werden die Zeitbereichsdaten gefenstert, die gefensterten Daten in Teilfolgen aufgeteilt und fouriertransformiert, und hieraus Periodigramme ermittelt, die zur Bestimmung der Übertragungsfunktion, in diesem Fall der Admittanz-Funktion, im Frequenzbereich herangezogen werden können.

Alternativ hierzu kann allerdings auch eine Korrelogramm-Methode, die in der Literatur auch unter dem Namen Blackman-Tukey-Schätzung bekannt ist, eingesetzt werden Dabei erfolgt die Spektralschätzung auf Grundlage einer Autokorrelationsfunktion (AKF) und einer Kreuzkorrelationsfunktion (KKF), die aus dem Testsignal (Anregungssignal) und dem Meßsignal (Antwortsignal) berechnet wird. Bei diesem Ansatz erhält man die spektrale Leistungsdichte durch Fourier-Transformation der zuvor geschätzten AKF und KKF. Die Welch-Methode liefert allerdings robustere Ergebnisse.

Ausgehend von der im Frequenzbereich vorliegenden Darstellung einer bekannten Übertragungsfunktion, beispielsweise des Admittanzverlaufs, können die Ersatzschaltbildparameter des Drehstrommotors extrahiert werden. Hierzu gibt es bereits einige numerische Ansätze. Besonders vorteilhaft kann der Levenberg-Marquardt-Algorithimus in einer Weiterbildung der Erfindung verwendet werden, um die Ersatzschaltbildparameter mittels einer Übertragungsfunktionsparameterbestimmung zu identifizieren. Alternativ kann beispielsweise ein Verfahren nach Nelder und Mead verwendet werden, wobei allerdings der Levenberg-Marquardt-Algorithmus, insbesondere bei stark verrauschten Datensätzen, robustere Ergebnisse liefert, Er gehört zur Gruppe von Gradienten-Verfahren, wobei durch iteratives Minimieren einer Fehlerfunktion bessere Parametervektoren berechnet werden können, die den Koeffizienten der Übertragungsfunktion entsprechen. Das Levenberg-Marquardt-Verfahren gilt momentan als Standardverfahren für nicht lineare Optimierungen. Es ist eine Mischung aus Gradienten-Verfahren und Inversion einer Hesse-Matrix und wird in der Literatur auch als Methode des steilsten Abstiegs bezeichnet. Die Inversion der Hesse-Matrix wird auch als Gauss-Newton-Verfahren bezeichnet. In Druckschrift [1] ist eine detaillierte Darstellung der Anwendung des Levenberg-Marquardt-Algorithmus vorgestellt, wobei ausgehend von einer Übertragungsfunktion:

$$G = \underline{Y} = \frac{1}{b_1 \quad s + b_0}$$

und unter Vorlage des Frequenzgangs des Systems die unbekannten Koeffizienten $b_0$ und $b_1$ bestimmt werden können. Im Vergleich mit der oben genannten Admittanzdarstellung entsprechen die Koeffizienten den pyhsikalischen Paramern $b_0 = R_1$, $b_1 = L_1$ . Durch die Ermittlung der unbekannten Koeffizienten $b_0$ und $b_1$ lassen sich die Ersatzschaltbildparameter $R_1$ und $L_1$ ermitteln.

Gemäß einer vorteilhaften Weiterbildung der Erfindung können die identifizierten Ersatzschaltbildparameter bei einer Einstellung und/oder Optimierung von Wechselrichter-Steuerparametern und/oder zur Motorüberwachung verwendet werden. Bei der Regelung moderner Synchronmaschinen werden Motorsteuerungsvorrichtungen eingesetzt, die bei schnellen Drehzahlübergängen oder bei Bereitstellung dynamisch regelbarer Abtriebsenergie aufgrund der Kenntnis der elektrischen Ersatzschaltbildparameter entsprechend den Wechselrichter steuern können bzw. die Strangantriebsspannungen derart vorgeben können, dass die Maschine optimal ohne Überschwingen die gewünschten Arbeitsaufgaben erfüllen kann. In diesem Zusammenhang werden die Begriffe Steuerung und Regelung synonym verwendet. Die Kenntnis der Ersatzschaltbildparameter der elektrischen Strecke kann folglich der Parametrierung des Stromreglers dienen, dessen Anforderung an eine hohe Dynamik als innerster Regler am höchsten ist. Insbesondere anspruchsvolle Regelungsverfahren, die über die von konventionellen PI-Reglern hinausgehen, verlangen eine sehr präzise Kenntnis der Maschinenparameter, insbesondere der Ersatzschaltbildparameter. Hierbei sind insbesondere Zustandsraumregler, Dead-Beat-Regler oder Modellfolgeregler zu nennen. Da in jüngster Zeit insbesondere sensorlose Motorsteuerungen eingesetzt werden, können mittels des vorgeschlagenen drehgeberlosen Verfahrens die Ersatzschaltbildparameter von bereits im mechanischen Antriebsstrang integrierten oder ausgetauschten Drehstrommotoren in einer komplexen Maschinenumgebung ermittelt werden, und der Motorregler vor Ort eingestellt werden. Die Ersatzschaltbildparameter geben das elektrische Motorverhalten wieder, so dass insbesondere bei der Regelung komplexer transienter Übergangsvorgänge der Maschine eine genaue Ansteuerung des Wechselrichters ermöglicht wird. Hierbei wird eine überschwingfreie Reglereinstellung und eine optimiert schnelle Dynamikregelung des Motors ermöglicht. Denkbar ist insbesondere die Anwendung einer solchen optimierten Motorregelung unter genauer Kenntnis der Ersatzschaltbildparameter im Bereich von Druckmaschinen, Kunststoffoberflächen-Herstell- und Bearbeitungsmaschinen oder von Walz- und Verpackungsmaschinen, bei denen dynamikoptimierte Motorsteuerungsverfahren eingesetzt werden müssen. Insbesondere bei Vierfarbdruckmaschinen können kleinste Abweichungen im Farbdruck bei Motorsteuerungsungenauigkeiten erkennbar werden. Bei der Herstellung extrem glatter und dünner Kunststoffoberflächen kann eine gleichmäßige Dicke der Kunststoffschicht nur bei optimaler Dynamikregelung erreicht werden, wobei keine optischen Verunreinigungen des Kunststoffmaterials auftreten können. Während der Analyse der Ersatzschaltbildparameter ruht der Rotor im Stillstand, und kann somit im eingebauten Zustand ohne Einfluss des Abtriebsstrangs elektrisch identifiziert werden. Eine Reglerparametrierung dient der Optimierung der Steuerparameter des Wechselrichters, wobei eine Abweichung der Ersatzschaltbildparameter von beispielsweise vorhergegangenen Messungen zur Fehlerüberwachung des Motors oder zur Verschleißkontrolle berücksichtigt werden kann. Insbesondere kann der Einsatz des Verfahrens im Rahmen eines "Condition Monitoring" des Motors vorteilhaft sein, so dass von Zeit zu Zeit das Verfahren die Ersatzschaltbildparameter neu ermitteln, adaptiv den Motorregler anpassen und bei auffälligen Abweichungen gegenüber zuvor identifizierten oder voreinstellbaren Parameterwerten eine Fehlersignalisierung ausgeben kann, so dass Motor oder Ansteuerelektronik überprüft werden können.

Gemäß eines nebengeordneten Aspekts der Erfindung wird eine Identifikationseinrichtung nach Anspruch 7 vorgeschlagen.

Somit betrifft diese Erfindung eine Identifikationseinrichtung, die dazu ausgelegt ist, ein vorgenanntes Verfahren auszuführen und hierzu die Möglichkeit eröffnet, mittels einer Wechselrichter-Interfaceeinheit mit einer Wechselrichter-Steuereinrichtung, insbesondere mit den Halbleiterschaltbauteilen des Wechselrichters zu kommunizieren, um diese zu schalten bzw. deren Betriebszustand abzufragen. Durch Deaktivierung des Wechselrichters und/oder Aktivierung einer Bremse für eine geraume Zeit kann ein Stillstand des Rotors feststellbar sein. Daneben können beispielsweise Drehzahl- oder Drehgebersensoren Aufschluss über einen Stillstand des Rotors und gegebenenfalls über einen Rotorwinkel $\beta_k$ der d-Achse gegenüber der $\alpha$-Achse geben. Diese Sensoren werden allerdings nicht zur Parameteridentifikation an sich benötigt, eine heuristische Kenntnis über einen angenommenen Rotorstillstand kann in den meisten Fällen genügen. Die Identifikationseinrichtung umfasst eine Testsignalerzeugungseinrichtung, die ein $d$-Testsignal erzeugen kann, wobei das Testsignal, insbesondere ein PRB-Rauschsignal, mittels einer U/V/W-Transformationseinheit in Abhängigkeit des Rotorwinkels $\beta_k$ in ein entsprechendes U/V/W-Steuertestsignal umgewandelt werden kann, das der Wechselrichter-Steuereinrichtung zuführbar ist. Das Steuertestsignal erzeugt in dem Motor ein entsprechendes Testsignal in den drei Motorsträngen. Des Weiteren umfasst die Identifikationseinrichtung eine d/q-Transformationseinheit, die die gemessenen $I_u$, $I_v$, und $I_w$ -Meßsignalströme in d/q -Meßsignalströme $I_d$ und $I_q$ umwandeln kann und eine Parameteridentifikationseinheit, die ausgehend von der im Zeitbereich vorliegenden Testsignalspannung $U_d$ und dem gemessenen Meßsignalstrom $I_d$ eine Parameteridentifikation nach vorgenannten Verfahren durchführen kann. Eine derartige Identifikationseinrichtung kann beispielsweise mehrteilig aufgebaut sein, wobei zur Erzeugung des Testsignals der Motorcontroller einer Motorsteuervorrichtung verwendet werden kann. Der gemessene Strom kann ebenfalls von der Motorsteuerungsvorrichtung aufgezeichnet werden. Ein externer Rechner kann die gemessenen und eingespeisten Spannungen und Ströme auslesen, in den Frequenzbereich transformieren und eine Parameteridentifikation durchführen.

Gemäß einer vorteilhaften Weiterbildung der Identifikationseinrichtung kann die Parameteridentifikationseinheit ein Fouriertransformationsmittel, insbesondere ein FFT/DFT-Mittel zur Fouriertransformation diskontinuierliche $d/q$-Abtast-Testsignalwerte nach dem Welch-Verfahren und ein Parameterbestimmungsmittel, insbesondere ein Levenberg-Marquardt-Übertragungsfunktions-Parameterbestimmungsmittel umfassen. Demgemäß umfasst die Parameteridentifikationseinheit ein Fouriertransformationsmittel zur Überführung der eingespeisten und gemessenen Spannungs- und Strom-Zeitabtastwerte $U_{1d}$, $I_{1d}$ und ein Parameterbestimmungsmittel, das ausgehend von der im Frequenzbereich vorliegenden Übertragungsfunktion $G_1$ eine Bestimmung der Übertragungsfunktionskoeffizienten $b_0$ und $b_1$ und hieraus der Systemparameter vornehmen kann. Die hierzu notwendigen Rechenverfahren können beispielsweise innerhalb eines DSPs, eines Mikrocontrollers eines FPGAs, eines PCs oder eines Kleinrechners durchgeführt werden, wobei eine logische und bauliche Trennung zwischen Testsignalerzeugung, Abtastwertspeicherung, Fouriertransformation und Parameterbestimmung möglich ist. Die Signalverarbeitung und das anschließende numerische Verfahren kann vorteilhaft als Softwareimplementierung zumindest teilweise auf einem Motorregler bzw. Motorsteuerungsvorrichtung vorgesehen sein.

So ist denkbar, das Fouriertransformationsmittel als FPGA aufzubauen, um eine schnelle Fouriertransformation mit Hilfe eines statischen Schaltkreises zu realisieren, und das Parameteridentifikationsmittel als variable Rechensoftware auf einem Hochleistungs-DSP eines Motorsteuerreglers zu implementieren. Eine Testsignalerzeugung und Abtastwertspeicherung kann innerhalb einer Wechselrichter-Motorsieuerungsvorrichtung durchgeführt werden. Fouriertransformation und Parameteridentifikation kann ebenfalls durch eine Motorsteuerungsvorrichtung oder durch eine externe Identifikationseinrichtung, die ein Interface zur Kommunikation mit der Motorsteuerungsvorrichtung aufweist, erfolgen. Somit kann die Motorsteuerungsvorrichtung mit geringer Rechenleistung ausgerüstet sein, und anspruchsvolle signaltheoretische Aufgaben in einer externen Identifikationseinrichtung, die an die Motorsteuerungsvorrichtung anschließbar ist, abgearbeitet werden, wodurch Hardwareaufwand eingespart werden kann.

Gemäß einer vorteilhaften Weiterbildung kann die Einrichtung des Weiteren eine Überwachungs- und Optimierungseinheit umfassen, die eingerichtet ist, auf Basis der identifizierten Ersatzschaltbildparameter Steuerparameter einer Wechselrichter-Steuereinrichtung zu bestimmen, zu optimieren und/oder zu überwachen. Die Überwachungs- und Optimierungseinheit empfängt die bestimmten Ersatzschaltbildparameter der Parameteridentifikationseinheit und kann auf Basis der bestimmten Ersatzschaltbildparameter Steuerungsparameter der Motorsteuervorrichtung optimieren, insbesondere hinsichtlich eines dynamischen Reglerverhaltens und/oder Filtereigenschaften, um die Auswirkungen des induktiven Verhaltens des Synchronmotors auf das Netz zu verringern. Des Weiteren kann ein effizienter Betrieb der Motorsteuerung optimiert und Motorveränderungen überwacht bzw. beim Motorausfall oder Fehlverhalten ein Fehlersignal ausgegeben werden. Die hierzu benötigten Ersatzschaltbildparameter können im Rahmen eines "Condition-Monitorings" durch die Überwachungs- und Optimierungseinheit routinemäßig nach einem bestimmten Zeitintervall oder beispielsweise bei Auswechseln des Motors oder Motorteilen erneut vorgenommen werden.

In einem nebengeordneten Aspekt schlägt die Erfindung eine Motorsteuerungsvorrichtung zur drehgeberlosen Steuerung bzw. Regelung eines Drehstrom-Synchronmotors vor, die eine zuvor beschriebene Identifikationseinrichtung zur drehgeberlosen Identifikation elektrischer Ersatzschaltbildparameter umfasst, wobei die identifizierten Ersatzschaltbildparameter zur Bestimmung, Optimierung und Überwachung des Motors und/oder der Motorsteuerung verwendbar sind. Somit schlägt dieser Aspekt eine Motorsteuerungsvorrichtung vor, die in üblicher Weise eine sensorbasierte oder drehgeberlose Steuerung des Drehzahlverhaltens des Synchronmotors vornehmen kann und die eine Identifikationseinrichtung umfasst oder in Verbindung mit einer solchen Identifikationseinrichtung steht, und die die identifizierten Ersatzschaltbildparameter zur Optimierung des Regelverhaltens, zur Bestimmung elektrischer Größen für die Ansteuerung des Motors und für die Überwachung eines fehlerfreien Verhaltens des Synchronmotors und/oder der Motorsteuerung verwendet. So können die ermittelten Ersatzschaltbildparameter zur optimalen Einstellung von Steuerungskennlinien dienen, so dass ein dynamisches Regelverhalten überschwingfrei ermöglicht werden kann. Somit können die identifizierten Parameter zur Optimierung des Stromverbrauchs und der Energieeffizienz des Synchronmotors herangezogen werden und beispielsweise für eine Filterparametrierung zur Einstellung elektronischer Filter eingesetzt werden oder sie können zur Überwachung des fehlerfreien Verhaltens der Motorsteuerungsvorrichtung und/oder des Synchronmotors herangezogen werden. Im Falle eines vorbestimmbaren Abweichens der identifizierten Parameter gegenüber zuvor bestimmten oder vorgegebenen Ersatzschaltbildparametern kann ein Fehlerfall angenommen werden, beziehungsweise eine Neubestimmung der Ersatzschaltbildparameter durchgeführt werden. Im Falle einer Reparatur oder einer Auswechslung des Motors kann die Motorsteuerungsvorrichtung adaptiv die Ersatzschaltbildparameter des neuen Motors identifizieren und sich optimiert auf den neuen Motor einstellen. Eine Selbstkalibrierung der Motorsteuerungsvorrichtung kann werksseitig erfolgen, oder beim Einbau der Maschine beim Kunden, beziehungsweise im laufenden Betrieb im Rahmen eines "Condition Monitorings".

In einer vorteilhaften Weiterbildung wird vorgeschlagen, dass die Motorsteuerungsvorrichtung derart eingerichtet ist, dass zumindest bei der erstmaligen Inbetriebnahme, bevorzugt mehrmals im Laufe des Betriebslebens, eine automatisierte Identifikation der Ersatzschaltbildparameter während eines Rotorstillstands vornehmbar ist, wobei bei einer vorstellbaren Abweichung der identifizierten Ersatzschaltbildparameter von vorherig bestimmten gespeicherten und/oder modellbezogenen Ersatzschaltbildparametern eine Fehlersignalisierung auslösbar ist. Somit schlägt dieser Aspekt vor, dass zumindest bei einer erstmaligen Inbetriebnahme, beziehungsweise einem Testlauf werksseitig, bevorzugt jedoch im Rahmen eines "Condition Monitorings", oder bei Reparatur oder Austausch von Teilen des Motors eine Parameteridentifikation vorgenommen wird, wobei die Motorsteuerungsvorrichtung zur

Optimierung, Einstellung und Überwachung des Motors diese Ersatzschaltbildparameter berücksichtigen kann. Somit kann eine "universelle" Motorsteuerungsvorrichtung geschaffen werden, die sich adaptiv an eine ganze Reihe unterschiedlicher Synchronmotoren anpassen kann, wobei im Motorstillstand eine Identifikation der elektrischen Größen vornehmbar ist. Alterungsbedingte Veränderungen des Motors können durch eine adaptive Korrektur der Reglerparameter berücksichtigt werden und Fehlfunktionen des Motors oder der Motorsteuerungsüberwachung können erkannt werden.

Schließlich wird in einem nebengeordneten Aspekt der Erfindung eine Verwendung des vorgenannten Verfahrens zur Bestimmung, Optimierung und Überwachung von Motorregelparametern für die Steuerung bzw. Regelung elektrischer Antriebe, insbesondere zur Einstellung von Regelungsparametern einer Motorsteuerungsvorrichtung vorgeschlagen. In diesem Aspekt wird vorgeschlagen, dass die ermittelten Ersatzschaltbildparameter zur Regleroptimierung, Parametrierung und Überwachung eingesetzt werden. Eine Ermittlung der Ersatzschaltbildparameter kann beispielsweise für eine Baureihe von Synchronmotoren einmalig an einem Mustermotor vorgenommen werden, und entsprechende Regelparameter für die hierfür eingesetzten Motorsteuerungsvorrichtungen optimiert und angepasst werden. Dies kann werksseitig erfolgen. Ist in einer Motorsteuerungsvorrichtung eine Identifikationseinrichtung vorgesehen oder extern anschließbar, so kann diese im eingebauten Zustand des Motors bei Erstinbetriebnahme, bei Reparaturmaßnahmen oder routinemässiger oder laufender Zustandsüberwachung ("Condition Monitoring") eine Neuidentifikation der Parameter vornehmen. Hierzu können Teile des Verfahrens, wie die Frequenzbereichstransformation und die Parameterbestimmung, auf einem externen Rechner ausgeführt werden, und andere Teile, wie beispielsweise die Einspeisung des Testsignals und die Konvertierung vom Dreiphasensystem in das Zweikoordinatensystem, innerhalb der Motorsteuerungsvorrichtung vorgenommen werden. Entscheidend ist jedoch, dass die identifizierten Ersatzschaltbildparameter zur optimalen Reglerparametrierung, Filtereinstellung, elektrischer Bauteildimensionierung verwendbar sind.

Zeichnungen

Weitere Vorteile ergeben sich aus der folgenden Zeichnungsbeschreibung. In der Zeichnung sind Ausführungsbeispiele der vorliegenden Erfindung dargestellt Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen,

Es zeigen beispielhaft:

**Fig. 1** ein Ersatzschaltbild einer Statorspule eines Synchronmotors in Sternschaltung;

**Fig. 2** Darstellung des Zusammenhangs zwischen Zweikomponenten- und Dreiphasenkoordinatensystems;

**Fig. 3** schematisch ein Aufbau eines Synchronmotors mit Kurzschlussläufer;

**Fig. 4** ein Ersatzschaltbild eines Synchronmotors;

**Fig. 5** ein erstes Ausführungsbeispiel einer Motorsteuerungsvorrichtung der Erfindung;

**Fig. 6** ein Ausführungsbeispiel einer Motorsteuerungsvorrichtung gemäß der Erfindung;

**Fig. 7** einen Ablaufplan eines Ausführungsbeispiels des erfindungsgemäßen Verfahrens;

**Fig. 8** schematisch ein Ausführungsbeispiel einer Testsignaleinspeisung in ein mathematisches Modell eines Synchronmotors;

**Fig.9** eine Betrag-Phasenvertauf einer Admittanz aus gemessenen Zeitbereichsdaten bei Anwendung eines erfindungsgemäßen Verfahrens;

**Fig.10** Rotorlageverhalten bei unsymmetrischer und symmetrischer Testsignaleinspeisung.

AUSFÜHRUNGSFORMEN DER ERFINDUNG

In den Figuren sind gleiche oder gleichartige Komponenten mit gleichen Bezugsziffern bezeichnet.

Zur Erläuterung der Erfindung zeigt Fig. 1 ein Ersatzschaltbild der Statorspule 01 eines Drehstrommmotors. Jeder Spulenstrang $U$, V und $W$ umfasst einen Widerstand $R_s$ 03 und eine Induktivität $L_s$ 05. Die drei Spulenstränge 07 sind an ihrem ersten Ende miteinander verbunden und an ihrem zweiten Ende an die drei Phasen $U$, V, $W$ des Ausgangs eines Wechselrichters angeschlossen. Die Statorspule 01 interagiert mit der drehbar gelagerten Rotorspule 11, die eine konstante Magnetisierung in einer $d$-Flussachsenrichtung aufweist. Das Rotormagnetfeld kann durch entlang des Rotorumfangs angebrachte Permanentmagnete oder durch einen über Schleifringe eingespeisten Gleichstrom in einer Rotorwicklung erzeugt werden. Das Rotormagnetfeld heftet sich an das sich drehende Statormagnetfeld und lässt somit den Rotor in der Frequenz des Statormagnetfeldes drehen. Das System aus Rotorspule 11 und Statorspule 01 kann statt in einem Drehphasensystem $U/V/W$ in einem Stator-Zweikoordinatensystem $\alpha/\beta$ oder Rotor-Zweikoordinatensystem $d/q$ betrachtet werden, woraus das in Fig. 4 dargestellte Ersatzschaltbild des Motors 09 abgeleitet werden kann.

Hierzu zeigt zunächst Fig. 2 die räumliche Zuordnung des Dreiphasensystems $UN/W$ mit den drei Koordinatenrichtungen 1 (0°), $e^{j2\Pi/3}$ (120°) und $e^{j4\Pi/3}$ (240°) gegenüber dem Koordinatensystem a/β der komplexen Ebene mit Realteil $\alpha$ und Imaginärteil $\beta$. Unter Annahme eines Gesamtstroms $I$ kann dieser in Bezug auf das Dreiphasensystem in drei Teilströme $I_u$, $I_v$ und $I_w$ aufgeteilt werden. In gleicher Weise kann der Strom durch die Teilströme in komplexen statorfesten Koordinatensystem $I_\alpha$ und $I_\beta$ ausgedrückt werden. Die Relation zwischen $I_\alpha$, $I_\beta$ und $I_u$, $I_v$ und $I_w$ sind bereits weiter oben angegeben worden. Unter Verwendung der komplexen Darstellung $I_\alpha$ und $I_\beta$, die die ortsfesten Statorachsenrichtungen angeben und den drei Strangströmen $I_u$, $I_v$ und $I_w$ können die obige Transformationsvorschrift hergeleitet werden. Der Rotor besitzt ein drehendes Koordinatensystem $d/q$, das die Rotor-Flussachse $d$ und Querflussachse q aufweist. Der Zusammenhang zwischen den sich drehenden Koordinaten $d/q$ und den ortsfesten Koordinaten $\alpha/\beta$ kann durch den Rotordrehwinkel $\beta_k$ hergestellt werden.

In Fig. 3 ist schematisch der Aufbau eines Permanentmagnet-Drehstrom-Synchronmotors 09 (PMSM) dargestellt. Dieser umfasst in einer einfachen Ausführung einen dreiphasigen Stator 13 mit den Spulensträngen U1, U2 (07-U), V1, V2 (07-V) und W1, W2 (07-W). Die ortsfesten Statorspulen definieren drei Spulenachsen A1, A2 und A3, die den in Fig. 2 gezeigten drei Phasenachsen 1, $e^{j2\Pi/3}$ und $e^{j4\Pi/3}$ entsprechen. Der Rotor 11 umfasst einen permanentbestückten Läufer, wobei sich das Permanentmagnetfeld des Rotors 11 an das sich elektrisch drehende Statormagnetfeld heftet und somit ein Drehmoment bewirkt, so dass der Rotor 11 in Drehung versetzt wird.

Des weiteren zeigt Fig. 4 das Ersatzschaltbild eines Synchronmotors mit dem Strangstrom $I_1$ und der Strangspannung $U_1$. Die Spannungsquelle $U_P$ stellt die Gegeninduktionswirkung des Rotormagnetfelds in der Läuferspule dar.

Das Ersatzschaltbild nach Fig. 4 beschreibt die elektrischen Vorgänge in der Statorspule 01 mit $R_1$, $L_1$ 03, 05. Auf Basis des Ersatzschaltbilds kann folgende Admittanzfunktion hergeleitet werden:

$$G = \underline{Y} = \frac{1}{R_1 + sL_1} = \frac{1}{b_0 + sb_1}$$

Aufgabe der vorliegenden Erfindung ist es nun, die in Fig. 4 dargelegten Ersatzschaltbildgrößen $R_1$, $L_1$ zu bestimmen. Ausgehend von der Kenntnis der Ersatzschaltbildgrößen kann bei eingespeisten Spannungen $U_d$ der sich einstellenden Strom $I_d$ vorhergesagt werden, wobei gewünschte Drehzahlen und Drehmomente durch Einstellung der Regelparameter optimiert werden können. Wesentlich dabei ist eine Beschreibung des transienten Verhaltens, wobei eine einzige Analyse des elektrischen Verhaltens des Motors möglichst genaue Kenntnis über die Ersatzschaltbildparameter liefert.

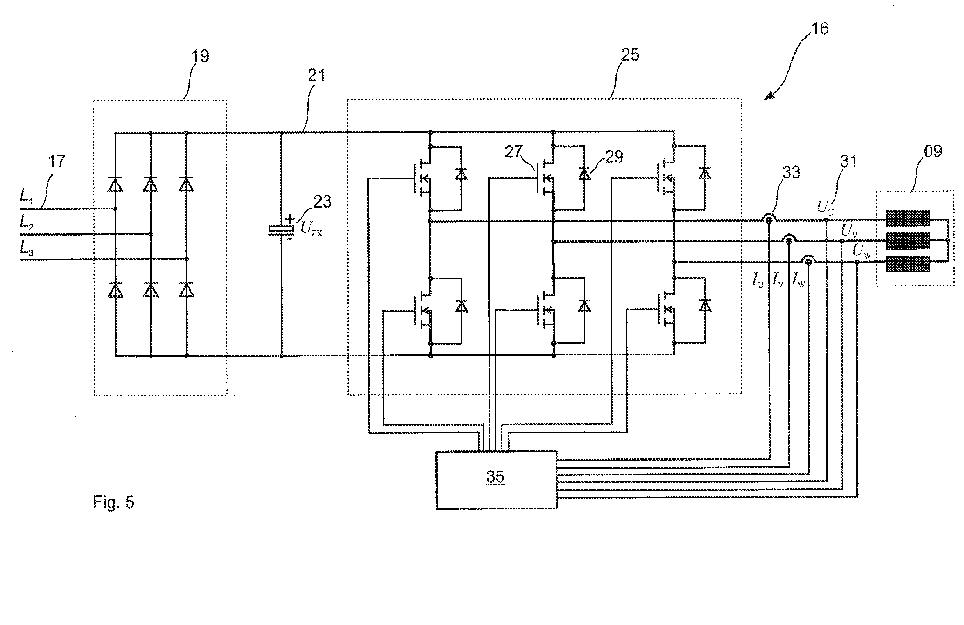

Fig. 5 zeigt schematisch eine Motoransteuerschaltung 16, bei der die Phasen eines Drehstromversorgungsnetzes 17 mittels eines Dreiphasen-Brückengleichrichters 19 in eine Gleichspannung eines DC-Zwischenkreises 21 umgewandelt werden. Im DC-Zwischenkreis 21 ist ein Pufferkondensator 23 vorgesehen, der die Spannung glättet und beispielsweise bei Stromausfall Pufferenergie für einen geregelten Notfahrbetrieb des Motors 09 zur Verfügung stellen kann. Ein Wechselrichter 25 umfasst drei Schaltbrücken, in denen Leistungshalbleiter-Schaltelemente 27 die Motorstränge $U/V/W$ gegenüber der Gleichspannung +DC und -DC des Zwischenkreises 21 koordiniert schalten können, und somit drehzahlvariabel eine PWM-modellierte Ansteuerspannung $U_u$, $U_v$, $U_w$ für den Drehstrommotor 09 bereitstellen. Jedes Leistungshalbleiterschaltelement 27, das ein IGBT-Transistor, ein Bipolar-Leistungstransistor oder Ähnliches umfassen kann, ist mittels einer Freilaufdiode 29 gegen Überspannung, insbesondere induktive Rückwirkung durch den Motor 09, geschützt. Die Strangspannungen $U_u$, $U_v$, $U_w$ 31 sowie Strangströme $I_u$, $I_v$, $I_w$ 33 werden in den Zuführleitungen zu dem Drehstrommotor 09 abgegriffen, und einer Motorsteuerungsvorrichtung 35 zugeführt. Die Strangspannungen müssen nicht notwendigerweise abgegriffen werden, da diese vom Wechselrichter 25 vorgegeben werden können, wobei angenommen wird, dass der Spannungssollwert dem Spannungsistwert entspricht.

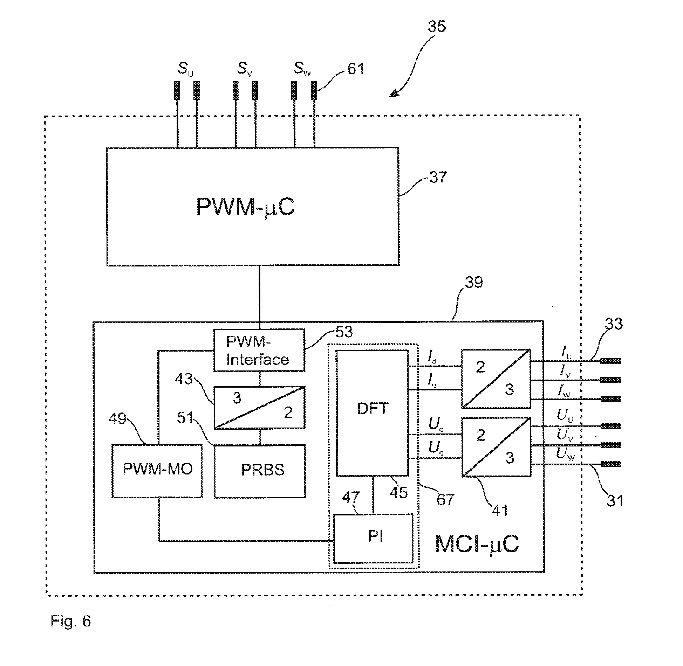

Die Motorsteuerungsvorrichtung 35 umfasst Steuerleitungen, um die einzelnen Leistungshalbleiterschaltelemente 27 je nach gewünschtem Drehzahlverhalten des Motors 09 phasenrichtig anzusteuern. Im Falle einer sensorbasierten Regelung ist die Motorsteuerungsvorrichtung 35 des Weiteren mit Positionswinkel- und Beschleunigungssensoren gekoppelt, wobei auch Temperatursensoren zur Überwachung der Betriebstemperatur des Motors 09 angeschlossen werden können. Im Falle einer drehgeberlosen feldorientierten Regelung kann die Motorsteuerungsvorrichtung 35 lediglich durch Kenntnis der Strangspannungen 31 und gemessenen Strangströmen 33 eine drehzahloptimierte Ansteuerung der Wechselrichter-Schaltbauteile 27 vornehmen. Die Regelparameter der Motorsteuerungsvorrichtung 35 können durch Kenntnis des elektrischen Verhaltens des Motors 09, der sich durch das in Fig. 4 dargestellte Ersatzschaltbild beschreiben lässt, eingestellt werden. Hierzu umfasst die Motorsteuerungsvorrichtung 35 eine Identifikationseinrichtung 39, wie sie in Fig. 6 dargestellt ist.

In der Fig. 6 ist ein Ausführungsbeispiel einer Motorsteuerungsvorrichtung 35 dargestellt, die eine Identifikationseinrichtung 39 zur Extraktion der Ersatzschaltbildparameter des Drehstrom-Synchronmotors 09 umfasst. Die Motorsteuerungsvorrichtung 35 weist Eingänge zur Erfassung der drei Strangströme $I_u$, $I_v$ und $I_w$ 33 sowie der drei Strangspannungen $U_u$, $U_v$ und $U_W$ 31 des Drehstrommotors 09 auf, wobei eine Erfassung von nur zwei Strangspannungen und Strangströmen genügt, da sich die dritte Größe nach Kirchhoff ergibt. Des Weiteren umfasst die Motorsteuerungsvorrichtung 35 Schaltausgänge 61 zur Ausgabe von Wechselrichter-Schaltsignalen zur Betätigung der Leistungshalbleiter-Schaltelemente 27 des Wechselrichters 25. Die phasenrichtige Erzeugung der Wechselrichter-Schaltsignale 61 erfolgt mittels eines PWM (Pulse-Width Modulation)-Mikrocontrollers, der eine Wechselrichter-Steuereinrichtung 37 darstellt, um sensorlos oder auch sensorgestützt eine Drehzahl- und Drehmomentregelung des Drehstrommotors 09 vorzunehmen. Die Identifikationseinrichtung 39 empfängt die Strangspannungen 31 und Strangströme 33 und umfasst eine $d/q$- Transformationseinheit 41, die Strangspannungen und Strangströme in die Teilspannung $U_d$, Uq sowie Teilströme $I_d$, $I_q$ des komplexen Zweikoordinatensystems umwandelt. Die umgewandelten Strangspannungen und Strangströme werden in eine Parameteridentifikationseinheit 67 eingespeist, die zum einen ein Fouriertransformationsmittel 45 und zum anderen ein Parameterextraktionsmittel 47 umfasst. Auf die Zeitbereichsdaten der Strangspannungen und Strangströme wird eine Fouriertransformation angewendet, so dass diese Daten im Frequenzbereich vorliegen und oben definierte Admittanz-Übertragungsfunktion $G_1$ gebildet werden kann. Anstelle der Admittanzfunktion können Parameter einer anderen Übertragungsfunktion, insbesondere Impedanzfunktion oder andere sinnvolle elektrische Funktionsbeziehungen zugrunde gelegt und deren Parameter bestimmt werden. Ausgehend von den Verläufen der Übertragungsfunktionen kann die Parameteridentifikationseinheit 67 des Parameterextraktionsmittels 47 unter Kenntnis der zugrunde liegenden Admittanz-Beschreibungsfunktion die zu identifizierende Parameter aus den Kurvenverläufen extrahieren. Hieraus können die Ersatzschaltbildparameter $R_1$, $L_1$ des in Fig. 4 dargestellten Ersatzschaltbilds ermittelt werden, und auf deren Basis kann eine Optimierungseinheit 49, die eine Modulierung des Motors sowie eine Optimierung von Parametereinstellungen der Pulsweitenerzeugung vornehmen kann, Steuerparameter sowie Filterparameter für die Parametrierung, Optimierung und Überwachung der Wechselrichter-Steuereinrichtung 37 erzeugen. Diese werden an ein PWM-Interface 53 weitergeleitet und können somit an die Wechselrichter-Steuereinrichtung 37 übermittelt werden, um eine optimale Regelung des Synchronmotors zu ermöglichen.

Im Rahmen der Parameterextraktion werden Testsignale eingespeist, die über eine Testsignalerzeugungseinheit 51 generiert werden können. In diesem Ausführungsbeispiel wird als Testsignal ein Pseudo-Rausch-Binär-Signal (PRBS) erzeugt, das mittels einer U/V/W-Transformationseinheit 43 das Rauschsignal gleichmäßig als $U_\alpha$/$U_\beta$ bereitstellt und auf die drei Strangspannungen $U_u$, $U_v$ und $U_w$ verteilt wird. Dieses Eingangssignal wird an die Wechselrichter-Steuereinrichtung 37 weitergeleitet, die entsprechend den Wechselrichter 25 so steuert, dass der Motor 09 entsprechend dem Testsignal bestromt wird.

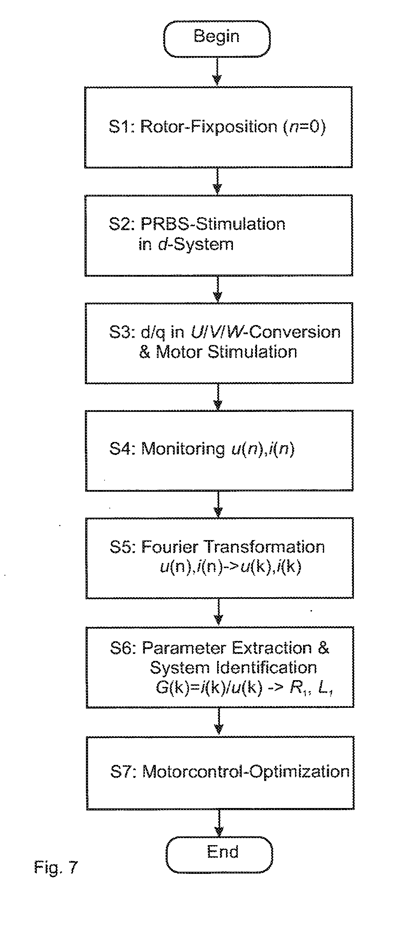

In der Fig. 7 ist ein Ausführungsbeispiel eines Programmablaufplans zur Durchführung eines erfindungsgemäßen Verfahrens dargestellt. In Schritt S1 wird zunächst der Rotor in einer definierte Fixposition und Stillstandslage gebracht, bei der die Umdrehungszahl n gleich 0 beträgt. In Schritt S2 wird die Einspeisung eines Testsignals als PRB-Signal in die $d$-Hauptmagnetflussachse des Rotors vorgenommen. Dies ist eine wesentliche Voraussetzung, so dass keine Drehmomente des Rotors auftreten können. Aus den $d/q$-Testsignalen wird eine Konversion in die Strangspannungen $U_u$, $U_v$ und $U_w$ durchgeführt und damit der Motor angesteuert. Die angesteuerten Spannungssignale U(n) sowie die gemessenen Stromwerte /(n) werden im Zeitbereich abgetastet und mittels einer Fouriertransformation, insbesondere einer DFT (Diskreten Fourier Transformation) oder FFT (Fast Fourier Transformation) unter Verwendung einer Welch-Methode, in den Frequenzbereich, d.h. in diesem Fall in den Laplace-Bereich überführt, so dass sich die Frequenzbereichswerte U(k), /(k) ergeben. Im Laplace-Bereich kann eine Übertragungsfunktion der Admittanz dargestellt werden als

$$G(\text{k}) = I(\text{k})/U(\text{k}),$$

die die Ausgangsbasis für die Parameterextraktion bildet. Unter Kenntnis der Obertragungsfunktion kann mittels einer Systemidentifikation eine Parameterextraktion, beispielsweise aufbauend auf den Levenberg-Marquadt-Algorithmus durchgeführt werden, um die Übertragungsfunktionskoeffizienten $b_o$ und $b_t$ aus dem Kurvenverlauf zu ermitteln. Hieraus können die Werte der Ersatzschaltbildparameter $R_1$, $L_1$ abgeleitet werden, und zur Einstellung von Motorsteuerungsparametern, zur Optimierung von Lastwechseln oder Drehmomentwechsein und zur Einstellung und Auslegung von Filterparametern für ein Filtern von Motorströmen oder Motorspannungen herangezogen werden. Durch die Kenntnis der Ersalzschaltbildparameter der elektrischen Strecke kann eine Parametrierung der Wechselrichter-Steuereinrichtung 37 vorgenommen werden, wobei eine hohe Dynamik des Motorverhaltens durch Optimierung des Regelverhaltens der Wechselrichter-Steuereinrichtung als innerster Regler erreicht werden kann. Dabei können anspruchsvolle Regelungsverfahren, die weit über die Möglichkeiten eines konventionellen PI-Reglers des Synchronmotors hinausgehen, erreicht werden, da eine präzise Kenntnis der elektrischen Maschinenparameter vorliegt, insbesondere können die Reglerparameter für einen Zustandsraumregler, einen Dead-Beat-Regler oder einer Modellfolgeregelung exakt eingestellt werden,

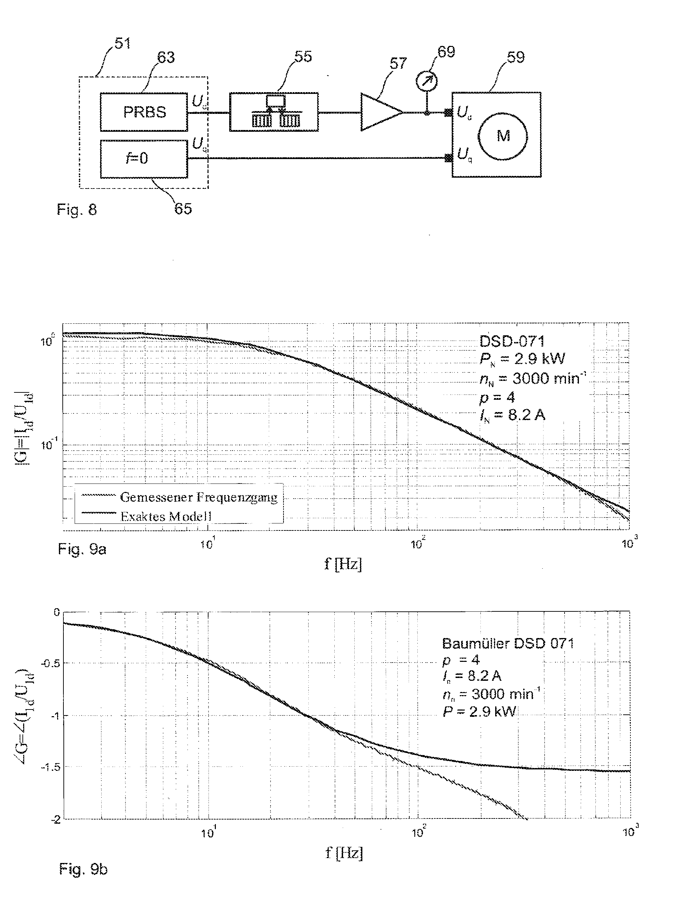

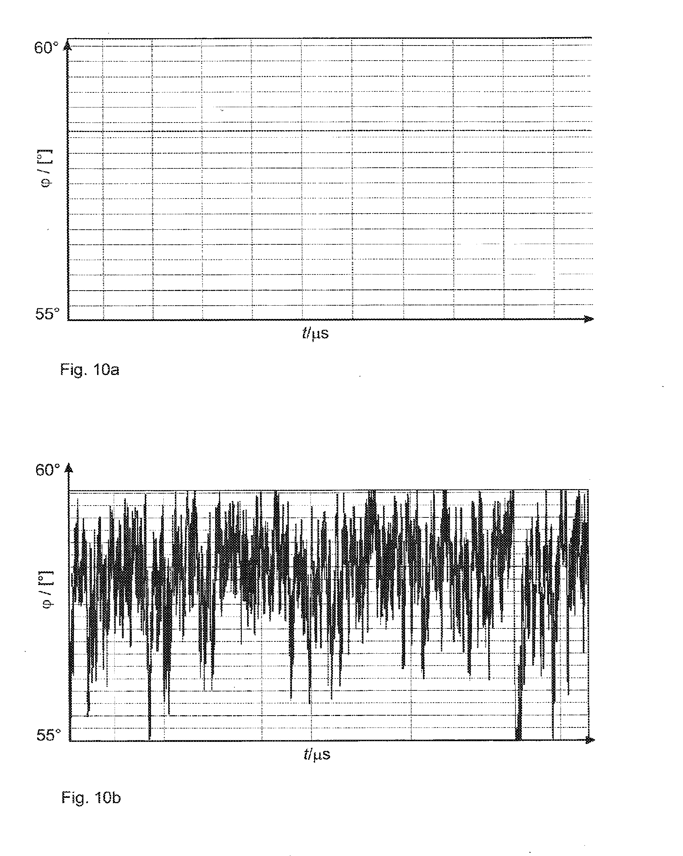

In der Fig. 8 ist schematisch die Einspeisung eines Testsignals einer Testsignal-Erzeugungseinheit 51 in ein mathematisches Modell eines Drehstrom-Synchronmotors 59 als $d/q$-Modell im Rahmen einer Matlab-Simulink Simulation dargestellt. Die Testsignal-Erzeugungseinheit 51 umfasst ein $d$-Testsignal-Erzeugungsmittel 63, das ein Pseudo-Rausch-Binärsignal erzeugt, welches im Takt einer Wechselrichter-Steuereinrichtung 37, die im Regelfall mit 16 kHz Taktrate, d.h. 62.5 $\mu$s Taktdauer arbeitet, bereitgestellt wird. Da das $d/q$-Motormodell 59 mit quasi analogen Signalen modelliert werden kann, ist eine Abtasterhöhungseinheit 55 zwischengeschaltet, die aus dem grob abgetasteten 16 kHz Testsignal ein quasi kontinuierliches Testsignal erzeugt. Dieses wird durch einen Testsignalverstärker 57 verstärkt als Motorspannung $U_d$ in das $d/q$ -Synchronmotormodell 59 eingespeist. Parallel hierzu erzeugt ein ebenfalls von der Testsignal-Erzeugungseinheit 51 umfasstes $q$-Testsignal-Erzeugungsmittel 65 ein Nullsignal oder ein Gleichspannungssignal, dass als Querachsenspannung $U$q in das Synchronmotormodell 59 eingespeist wird. Eine Simulation erfolgt dabei mit Matlab-Simulink, um eine mathematische Verifikation des Verfahrens durchzuführen. Ausgehend von der numerischen Simulation werden die Verläufe der Strangströme durch eine Signalaufzeichnungseinheit 69 aufgezeichnet, woraus sich ein resultierendes Drehmoment von 0 ergibt, wie in Fig. 10a dargestellt. Dementsprechend kann gefolgert werden, dass bei den dem Verfahren zugrunde liegenden Ausgangsgleichungen ein stillstehender drehmomentfreier Rotor bei unsymmetrischer Einspeisung des Testsignal zu erwarten ist.

In Fig. 9a und 9b ist ein Betrags- und Phasenverlauf über einen Frequenzbereich von 0-1 kHz der Admittanz-Funktion $G = \underline{Y}$, die aus dem identifizierten elektrischen System und aus den exakten Maschinenmodell abgeleitet wurde, dargestellt. Deutlich ist zur erkennen, dass die Übertragungsfunktionen $G_1$ nahezu identisch mit dem exakten Maschinenmodell Übereinstimmen und ein theoretisch vorhersehbares PT1-Verhalten aufweist. Der betrachtete Motor ist ein Baumüller DSD071 Motor mit einer Nennleistung von $P_N$=2,9 KW, Nenndrehzahl $_nN$=3000$^{-1}$, einer Polpaarzahl p=4 und einem Nennstrom $_{/N}$=8.2 A. Somit kann mittels numerischer Simulation eine Verifikation des theoretischen Modells nachgewiesen werden. Ausgehend von dem im Zeitbereich gemessenen abgetasteten Strangspannungen und Strangströmen kann eine nahezu identische Systemcharakterisierung des elektrischen Verhaltens des Drehstrommotors 09 abgeleitet werden.

In Fig. 10a ist ein Oszillogrammverlauf der gemessenen Positionssignale während der Selbstidentifikation bei Verwendung eines erfindungsgemäßen. Verfahrens dargestellt. Man erkennt, dass der Drehwinkel φ des Rotors 11 während der Testsignaleinspeisung und Messung stillsteht, da im Falle einer unsymmetrischen Einspeisung der Testsignale kein Drehmoment erzeugt Wird, das den Rotor 11 in Drehung versetzen kann, Anders liegt es jedoch im Rotorwinkelverlauf φ nach Fig. 10b, wobei in diesem Fall zur Gegenkontrolle eine symmetrische Testsignaleinspeisung in beide Kanäle *d/q* des Synchronmotors 09 vorgenommen wurde. Deutlich ist zu erkennen, dass bei einer Einspeisung in die *d-* sowie in die *q-*Achse der Rotor während der Messung nicht still steht, sondern sich hochfrequent hin- und her bewegt, In einem eingebauten Zustand würde der mechanische Antriebsstrang bewegt, bzw. eine Messung durch den Antriebsstrang verfälschte Werte liefern. Somit ist dargelegt, dass lediglich eine unsymmetrische Einspeisung des Testsignals in die *d-*Koordinatenrichtungen des Motors 09 verwertbare Ergebnissen liefert,

Die grundsätzliche idee der Erfindung beruht auf einer signal theoretischen Betrachtung eines Drehstrom-Elektromotors in einem Zweikoordinatenraum *d/q,* wobei mittels unsymmetrischer Einspeisung eines breitbandigen Testsignals, bevorzugt eines PRB-Signals, als Motorspannungen in Richtung der *d-*Hauptmagnetflussachse des Rotors, Auswertesignale, Meßsignale als Motorströme gemessen vorliegen, die in den Frequenzbereich mittels bevorzugt eines Welch-Verfahrens transformiert werden können. Aufbauend darauf können Übertragungsfunktionen aus den eingespeisten und gemessenen Signalen extrahiert werden und mittels einer Parametendentifikationsmethode, bevorzugt einem Levenberg-Marquardt-Algorithmus, die zugrunde liegenden Systembeschreibungsparameter ausgewertet werden, Durch Kenntnis des formelmäßigen Zusammenhangs der Übertragungsfunktionen können die einzelnen Funktionsparameter identifiziert und damit das elektrische Verhalten des Motors über einen großen Frequenzbereich charakterisiert werden. Besonderen Schwerpunkt legt die Erfindung auf die besondere Einspeisungsart, die Struktur der Übertragungsfunktion und die Analysevorschrift, bei der im Stillstand des Rotors eine Bestimmung der elektrischen Ersatzschaltbildgrößen ermöglicht wird. Das Verfahren bildet das transiente Verhalten des Motors über einen großen Arbeitsfrequenzbereich bzw. Drehzahlbereich ab und kann zur Einstellung, Optimierung und Überwachung des Motors verwendet werden. Insbesondere bei Einsatz in einer Motorsteuerungsvorrichtung kann eine universelle Motorsteuerungsvorrichtung bereitgestellt werden, die adaptiv werksseitig oder nach Einbau des Motors bei Verkopplung mit einem mechanischen Abtriebsstrang zur Bestimmung des Motorverhaltens benutzt werden kann. Eine motorschonende und schnelle Bestimmung der maschinenbeschreibenden Parameter wird dadurch ermöglicht. Das Verfahren kann softwaretechnisch in bestehenden Motorsteuerungsvorrichtungen wie beispielsweise den Baumüller b_maXX-Motorsteuerungen und Servoregler, insbesondere b_maXX 1000-5000 nachgerüstet werden und eröffnet eine automatisierte Identifikation und Überwachung der motorbeschreibenden Parameter.

**Bezugszeichenliste**

01    Statorspulen-Ersatzschaltbild eines Synchronmotors
03    Spulenwiderstand
05    Spuleninduktivität
07    U/V/W-Spulenstrang
09    Synchronmotor
11    Rotor
13    Stator
15    Ersatzschaltbild einer Ständerspule eines Synchronmotors
16    Motoransteuerschaltung
17    AC-Versorgungsnetz
19    Dreiphasen-Brückgleichrichter
21    DC-Zwischenkreis
23    Pufferkondensator
25    Wechselrichter
27    Leistungshalbleiter-Schaltelement
29    Freilaufdiode
31    Strangspannung
33    Strangstrom
35    Motorsteuerungsvorrichtung

37 Wechselrichter-Steuereinrichtung
39 Identifikationseinrichtung
41 $\alpha/\beta$-Transformationseinheit
43 U/V/W-Transformationseinheit
45 Fouriertransformationsmittel
47 Parameterbestimmungsmittel
49 Optimierungseinheit
51 Testsignal-Erzeugungseinheit
53 Wechselrichtersteuerungs-Interfaceeinheit
55 Abtastratenerhöhungseinheit
57 Testsignalverstärker
59 $\alpha/\beta$-Synchronmotor-Modell
61 Wechselrichter-Schaltsignale
63 $d$-Testsignal-Erzeugungsmittel
65 $q$-Testsignal-Erzeugungsmittel
67 Parameteridentifikationseinheit
69 Signalaufzeichnungseinheit

**Patentansprüche**

1. Verfahren zur drehgeberlosen Identifikation elektrischer Ersatzschaltbildparameter (03, 05, 15) eines Drehstrom-Synchronmotors (09),
   **dadurch gekennzeichnet, dass**
   es zumindest die Schritte umfasst:

   - Stillstandslagensuche des Rotors (11), so dass $d$-Flussachsenrichtung des Läuferflusses des Rotors gegenüber der einen Realteil eines komplexen Zweikoordinatensystems des Gesamtstroms bezeichnenden $\alpha$-Achsenrichtung des Stators (13) ausgerichtet ist;
   - Frequenzgangsmessung durch Testsignalspannungseinspeisung ($U_{1d}$) in $d$-Flussachsenrichtung des Synchronmotors (09), wobei die zur d-Flussachsenrichtung rechtwinklige $q$-Querachsenrichtung als Querflussachse unbestromt bleibt;
   - Meßsignalstrommessung ($I_{1d}$) der $d$-Flussachsenrichtung des Synchronmotors (09);
   - Identifikation von Ersatzschaltbildparametern (03, 05, 15) des Synchronmotors (09) auf Basis der digital erfassten zeitlichen Abtastwerte der Testsignalspannung ($U_{1d}$) und des Meßsignalstroms ($I_{1d}$) in $d$-Flussachsenrichtung durch Analyse des Frequenzgangs der gemessenen Übertragungsfunktion unter Kenntnis der Übertragungsfunktion im Frequenzbereich eines Ersatzschaltbildes eines Synchronmotors mittels Parameterextraktion;

   wobei die Testsignaleinspeisung in den Synchronmotor (09) derart erfolgt, dass der Rotor (11) drehmomentfrei bleibt.

2. Verfahren nach Anspruch 1,
   **dadurch gekennzeichnet,**
   **dass** die Stillstandslage eine Rastlage des Rotors (11) ist, bei der d-Flussachsenrichtung mit der $\alpha$-Achsrichtung übereinstimmt, oder eine vorbekannte Rotorlage oder eine erzwungene Stillstandszwangslage durch Konstantbestromung des Synchronmotors (09) in eine $\alpha$-Achsenrichtung ist.

3. Verfahren nach einem der vorangegangenen Ansprüche,
   **dadurch gekennzeichnet,**
   **dass** das Testsignal ein Pseudo-Rausch-Binär-Signal ist.

4. Verfahren nach einem der vorangegangenen Ansprüche,
   **dadurch gekennzeichnet,**
   **dass** die Identifikation der Ersatzschaltbildparameter (03, 05, 15) eine Fouriertransformation von zeitdiskreten Signalen nach einem Welch-Verfahren umfasst.

5. Verfahren nach einem der vorangegangenen Ansprüche,
   **dadurch gekennzeichnet,**

**dass** die Identifikation der Ersatzschaltbildparameter (03, 05, 15) eine Übertragungsfunktion-Parameterbestimmung insbesondere nach einem Levenberg-Marquardt-Algorithmus umfasst.

6. Verfahren nach einem der vorangegangenen Ansprüche,
   **dadurch gekennzeichnet,**
   **dass** die identifizierten Ersatzschaltbildparameter (03, 05, 15) bei einer Einstellung und/oder Optimierung von Wechselrichter-Steuerparametern und/oder zur Motorüberwachung verwendet werden.

7. Identifikationseinrichtung (39) zur drehgeberlosen Identifikation elektrischer Ersatzschaltbildparameter (03, 05, 15) eines Drehstrom-Synchronmotors (09), der von einer eine Wechselrichter-Steuerungsvorrichtung (37) enthaltenden Steuerung (35) gesteuert ist,
   **gekennzeichnet dadurch,**
   **dass** die Identifikationseinrichtung (39)

   - eine Wechselrichter-Interfaceeinheit (53), die zur steuernden Kommunikation und zur Rotorpositionsbestimmung mit der Wechselrichter-Steuereinrichtung (37) verbindbar ist, derart, dass eine Stillstandslagensuche des Rotors (11) ermöglicht ist, so dass die $d$-Flussachsenrichtung des Läuferflusses des Rotors gegenüber der einen Realteil eines komplexen Zweikoordinatensystems des Gesamtstroms bezeichnenden $\alpha$-Achsenrichtung des Stators (13) ausgerichtet ist
   - des Weiteren eine Testsignalerzeugungseinrichtung (51) zur Erzeugung eines $d/q$-Testsignals in Form einer Testsignalspannung ($U_{1d}$), wobei eine Frequenzgangsmessung durch Testsignalspannungseinspeisung ($U_{1d}$) in $d$-Flussachsenrichtung des Synchronmotors (09) ermöglicht ist, wobei die zur d-Flussachsenrichtung rechtwinklige $q$-Querachsenrichtung als Querflussachse unbestromt bleibt, wobei die Testsignaleinspeisung in den Synchronmotor (09) derart erfolgt, dass der Rotor (11) drehmomentfrei bleibt,
   - eine $U/V/W$-Transformationseinheit (43) zur Transformation des $d/q$-Testsignals in ein dem Motor (09) zugeführtes $U/V/W$-Steuertestsignal,
   - eine $d/q$ Transformationseinheit (41) zur Transformation gemessener $U/V/W$-Meßsignalsströme in $d/q$ Meßsignalsströme ($I_{1d}$) zur Meßsignalstrommessung ($I_{1d}$) der $d$-Flussachsenrichtung des Synchronmotors (09) und
   - eine Parameteridentifikationseinheit (67) zur Identifikation von Ersatzschaltbildparametern (03, 05, 15) auf Basis der digital erfassten zeitlichen Abtastwerte der Testsignalspannung ($U_{1d}$) und des Meßsignalstroms ($I_{1d}$) in $d$-Flussachsenrichtung durch Analyse des Frequenzgangs der gemessenen Übertragungsfunktion unter Kenntnis der Übertragungsfunktion im Frequenzbereich eines Ersatzschaltbildes eines Synchronmotors mittels Parameterextraktion umfasst.

8. Einrichtung nach Anspruch 7,
   **dadurch gekennzeichnet,**
   **dass** die Parameteridentifikationseinheit (67) ein Fouriertransformationsmittel (45), insbesondere ein FFT/DFT-Mittel zur Fouriertransformation diskontinuierlicher $d/q$-Signalwerte nach dem Welch-Verfahren, und ein Parameterbestimmungsmittel (47), insbesondere ein Levenberg-Marquardt-Übertragungsfunktions-Parameterbestimmungsmittel, umfasst.

9. Einrichtung nach einem der Ansprüche 7 oder 8,
   **dadurch gekennzeichnet,**
   **dass** des Weiteren eine Überwachungs- und Optimierungseinheit (49) umfasst ist, die eingerichtet ist, auf Basis der identifizierten Ersatzschaltbildparameter (03, 05, 15) Steuerparameter einer Wechselrichter-Steuereinrichtung (37) zu bestimmen, zu optimieren und/oder zu überwachen.

10. Motorsteuerungsvorrichtung (35) zur drehgeberlosen Steuerung eines Drehstrom-Synchronmotors (09)
    **gekennzeichnet dadurch,**
    **dass** eine Identifikationseinrichtung (39) zur drehgeberlosen Identifikation elektrischer Ersatzschaltbildparameter (03, 05, 15) eines Drehstrom-Synchronmotors (09) nach einem der vorgenannten Ansprüche 7 bis 10 umfasst ist, wobei die identifizierten Ersatzschaltbildparameter (03, 05, 15) zur Bestimmung, Optimierung und Überwachung des Motors (09) und/oder der Motorsteuerung verwendbar sind.

11. Vorrichtung nach Anspruch 10,
    **dadurch gekennzeichnet,**
    **dass** die Vorrichtung dergestalt eingerichtet ist, dass zumindest bei der erstmaligen Inbetriebnahme, bevorzugt mehrmals im Laufe des Betriebslebens eine automatisierte Identifikation der Ersatzschaltbildparameter (03, 05, 15) während eines Rotorstillstand vornehmbar ist, wobei bei einer voreinstellbaren Abweichung der identifizierten Ersatzschaltbildparameter (03, 05, 15) von vorherig bestimmten, gespeicherten und/oder modellbezogenen Ersatzschaltbildparametern (03, 05, 15) eine Fehlersignalisierung auslösbar ist.

12. Verwendung eines Verfahrens nach einem der vorangegangenen Verfahrensansprüche zur Bestimmung, Optimierung und Überwachung von Reglerparametern für die Steuerung elektrischer Antriebe, insbesondere zur Einstellung von Regelungsparametern einer Motorsteuerungsvorrichtung (35).

**Claims**

1. A method for the identification without shaft encoder of electrical equivalent circuit parameters (03, 05, 15) of a three-phase synchronous motor (09) **characterized in that**
   comprising at least the steps:

   - standstill position search of the rotor (11) so that the d- flux axial direction of the rotor flux of the rotor is aligned with respect to the $\alpha$- axial direction, which describes a real part of a complex two coordinate system of the total current, of the stator (13);
   - frequency response measurement by supplying test signal voltage ($U_{1d}$) in the d- flux axial direction of the synchronous motor (09), wherein the q-transverse axial direction designed as a transverse flow axis, which is orthogonal with respect to the d- flux axial direction, remains free of current;
   - measuring signal current measurement ($I_{1d}$) of the d- flux axial direction of the synchronous motor (09);
   - identification of equivalent circuit parameters (03, 05, 15) of the synchronous motor (09) based on the digitally recorded time samples of the test signal voltage ($U_{1d}$) and on the measuring signal current ($I_{1d}$) in the d- flux axial direction by analyzing the frequency response of the measured transfer function with knowledge of the transfer function in the frequency range of an equivalent circuit diagram of a synchronous motor by means of parameter extraction;

   wherein the supplying of a test signal into the synchronous motor (09) takes place in such a manner that the rotor (09) remains free of torque.

2. The method according to Claim 1,
   **characterized in that**
   the standstill position is a rest position of the rotor (11), at which the d flux axial direction coincides with the $\alpha$ axial direction, or is a previously known rotor position or a forced standstill obligatory position by a constant supplying of the synchronous motor (09) with current in an $\alpha$ axial direction.

3. The method according to one of the previous claims,
   **characterized in that**
   the test signal is a pseudo-noise binary signal.

4. The method according to one of the previous claims,
   **characterized in that**
   the identification of the equivalent circuit parameters (03, 05, 15) comprises a Fourier transformation of time-discrete signals according to a Welch method.

5. The method according to one of the previous claims,
   **characterized in that**
   the identification of the equivalent circuit parameters (03, 05, 15) comprises a transmission function determination of parameters, in particular according to a Levenberg-Marquardt algorithm.

6. The method according to one of the previous claims,
   **characterized in that**
   the identified equivalent circuit parameters (03, 05, 15) are used in an adjustment and/or optimization of inverter control parameters and/or for motor monitoring.

7. An identification apparatus (39) for the identification without shaft encoder of electrical equivalent circuit parameters (03, 05, 15) of a three-phase synchronous motor (09), which is controlled by a control device (35), which contains an inverter control device (37),
**characterized in that**
the identification device (39) comprises

- an inverter interface unit (53), that can be connected to the inverter control device (37) for the controlling communication and for the determination of the rotor position such that a standstill position search of the rotor (11) is possible so that the d- flow axis direction of the rotor flux of the rotor is aligned relative to the $\alpha$- axis direction of the stator (13), which describes a real part of a complex two coordinate system of the total current,
- furthermore a test signal creation device (51) for creating a d/q- test signal in the form of a test signal voltage ($U_{1d}$), wherein a frequency response measurement is made possible by means of a test signal voltage feed ($U_{1d}$) in d- flux axis direction of the synchronous motor (09), wherein the q- transverse axis direction, which is rectangular with respect to the d - flux axis direction, as a cross flux axis remains current-free, wherein the test signal feed to the synchronous motor (09) takes place such that the rotor (11) remains torque-free;
- a U/V/W transformation unit (43) for transforming the d/q test signal into an U/V/W control test signal, which is supplied to the motor (09)
- a d/q transformation unit (41) for transforming measured U/V/W measuring signal currents into d/q measuring signal currents ($I_{1d}$) for the measuring signal current measurement ($I_{1d}$) of the d- flux axis direction of the synchronous motor (09) and
- a parameter identification unit (67) for identifying equivalent circuit parameters (03, 05, 15) based on the digitally recorded time samples of the test signal voltage ($U_{1d}$) and of the measured signal current ($I_{1d}$) in d-flux axis direction by analyzing the frequency response of the measured transfer function with taking note of the transfer function in the frequency range of an equivalent circuit of a synchronous motor in the frequency range of an equivalent circuit of a synchronous motor by means of parameter extraction.

8. The apparatus according to Claim 7,
**characterized in that**
the parameter identification unit (67) comprises a Fourier transformation means (45), in particular an FFT/DFT means for the Fourier transformation of discontinuous d/q signal values according to the Welch method and comprises a parameter determination means (47), in particular a Levenberg-Marquardt transmission function-parameter determination means.

9. The apparatus according to one of Claims 7 or 8,
**characterized in that**
a monitoring and optimization unit (49) is furthermore comprised that is set up to determine, optimize and/or monitor control parameters of an inverter control apparatus ((37) on the basis of the identified equivalent circuit parameters (03, 05, 15).

10. A motor control device (35) for the shaft-encoderless control of a three-phase asynchronous motor (09),
**characterized in that**
an identification apparatus (39) for the shaft-encoderless identification of electrical equivalent circuit parameters (03, 05, 15) of a three-phase synchronous motor (09) according to one of the previous claims 7 to 10 [sic] is comprised, wherein the identified equivalent circuit parameters (03, 05, 15) can be used for the determination, optimization and monitoring of the motor control.

11. The device according to Claim 10,
**characterized in that**
the device is arranged in such a manner that an automated identification of the equivalent circuit parameters (03, 05, 15) can be performed during a rotor standstill at least during the first startup, preferably several times in the course of the service life, wherein an error signal can be initiated upon a demonstrable deviation of the equivalent circuit parameters (03, 05, 15) from previously determined, stored and/or model-related equivalent circuit parameters (03, 05, 15).

12. The use of a method according to one of the previous method claims for determining, optimizing and monitoring motor regulator parameters for the control of electrical drives, in particular for the adjusting of regulator parameters of a motor control device (35).

**Revendications**

1. Procédé d'identification sans codeur de paramètres (03, 05, 15) d'un circuit électrique équivalent d'un moteur synchrone triphasé (09), **caractérisé en ce qu'**il comprend au moins les étapes suivantes :

   - recherche de la position d'arrêt du rotor (11) de façon telle que la direction axiale $d$ du flux rotorique du rotor est aligné à l'opposé de la direction axiale $\alpha$ du stator (13) désignant une partie réelle d'un système complexe à deux coordonnées du courant total ;
   - mesure de réponse en fréquences par injection d'une tension de signal de test ($U_{1d}$) dans la direction axiale de flux $d$ du moteur synchrone (09), la direction transversale $q$ en tant qu'axe de flux transversal perpendiculaire à la direction axiale de flux $d$ restant non alimentée ;
   - mesure de l'intensité du signal de mesure ($I_{1d}$) de la direction axiale de flux $d$ du moteur synchrone (09) ;
   - identification de paramètres (03, 05, 15) du circuit équivalent du moteur synchrone (09) sur la base des valeurs d'échantillonnage temporelles enregistrées numériquement de la tension du signal de test ($U_{1d}$) et de l'intensité du signal de mesure ($I_{1d}$) dans la direction axiale de flux $d$ par analyse de la réponse en fréquences de la fonction de transfert mesurée, connaissant la fonction de transfert dans la plage de fréquence d'un circuit équivalent d'un moteur synchrone par la technique d'extraction de paramètres ;

   l'injection du signal de test dans le moteur synchrone (09) s'effectuant de telle sorte que le rotor (11) reste sans couple.

2. Procédé selon la revendication 1, **caractérisé en ce que** la position d'arrêt est une position d'arrêt instantané du rotor (11), dans laquelle la direction axiale de flux $d$ coïncide avec la direction axiale $\alpha$, ou une position de rotor préalablement connue ou une position d'arrêt forcée par alimentation en courant constante du moteur synchrone (09) dans une direction axiale $\alpha$.

3. Procédé selon l'une des revendications précédentes, **caractérisé en ce que** le signal de test est un signal binaire de pseudo-bruit.

4. Procédé selon l'une des revendications précédentes, **caractérisé en ce que** l'identification des paramètres de circuit équivalent (03, 05, 15) comprend une transformée de Fourier de signaux valeurs discrètes en temps selon un procédé de Welch.

5. Procédé selon l'une des revendications précédentes, **caractérisé en ce que** l'identification des paramètres de circuit équivalent (03, 05, 15) comprend une détermination de paramètres par fonction de transfert, en particulier selon un algorithme de Levenberg-Marquardt.

6. Procédé selon l'une des revendications précédentes, **caractérisé en ce que** les paramètres de circuit équivalent (03, 05, 15) identifiés sont utilisés lors d'un réglage et/ou d'une optimisation de paramètres de commande d'onduleur et/ou pour la surveillance du moteur.

7. Dispositif d'identification (39) sans codeur de paramètres (03, 05, 15) d'un circuit électrique équivalent d'un moteur synchrone triphasé (09) qui est commandé par un dispositif de commande (35) comprenant un dispositif de commande d'onduleur (37),
   **caractérisé en ce que** le dispositif d'identification (39) comprend :

   - une unité d'interface d'onduleur (53) qui peut être reliée au dispositif de commande d'onduleur (37) pour assurer la communication de commande et la détermination de la position du rotor, de façon à permettre une recherche de position d'arrêt du rotor (11) de sorte que la direction axiale $d$ du flux rotorique du rotor est alignée à l'opposé de la direction axiale $\alpha$ du stator (13) désignant une partie réelle d'un système complexe à deux coordonnées du courant total ;
   - en outre un dispositif de génération de signal de test (51) destiné à générer un signal de test $d/q$ sous la forme d'une tension de signal de test ($U_{1d}$), permettant une mesure de réponse en fréquences par injection de tension de signal de test ($U_{1d}$) dans la direction axiale de flux $d$ du moteur synchrone (09), la direction transversale $q$ en tant qu'axe de flux transversal perpendiculaire à la direction axiale de flux $d$ restant non alimentée, l'injection du signal de test dans le moteur synchrone (09) s'effectuant de telle sorte que le rotor (11) reste sans couple,
   - une unité de transformation $U/V/W$ (43) destinée à transformer le signal de test $d/q$ en un signal de test de commande $U/V/W$ délivré au moteur (09),
   - une unité de transformation $d/q$ (41) destinée à transformer des courants de signaux de mesure $U/V/W$ mesurés en intensités de signaux de mesure $d/q$ ($I_{1d}$) pour la mesure d'intensité du signal de mesure ($I_{1d}$) de la direction axiale de flux $d$ du moteur synchrone (09), et

- une unité d'identification de paramètres (67) destinée à l'identification de paramètres de circuit équivalent (03, 05, 15) sur la base des valeurs d'échantillonnage temporelles enregistrées numériquement de la tension de signal de test ($U_{1d}$) et de l'intensité du signal de mesure ($I_{1d}$) dans la direction axiale de flux $d$ par analyse de la réponse en fréquences de la fonction de transfert mesurée, connaissant la fonction de transfert dans la plage de fréquence d'un circuit équivalent d'un moteur synchrone par la technique d'extraction de paramètres.

8. Dispositif selon la revendication 7, **caractérisé en ce que** l'unité d'identification de paramètres (67) comprend un moyen de transformée de Fourier (45), en particulier un moyen FFT/DFT pour la transformée de Fourier de valeurs de signaux $d/q$ discontinues selon le procédé de Welch, et un moyen de détermination de paramètres (47), en particulier un moyen de détermination de paramètres par fonction de transfert de Levenberg-Marquardt.

9. Dispositif selon l'une des revendications 7 ou 8, **caractérisé en ce qu'**il comporte en outre une unité de surveillance et d'optimisation (49) qui est conçue pour déterminer, optimiser et/ou surveiller des paramètres de commande d'un dispositif de commande d'onduleur (37) sur la base des paramètres de circuit équivalent (03, 05, 15) identifiés.

10. Dispositif de commande de moteur (35) pour la commande sans codeur d'un moteur synchrone triphasé (09) **caractérisé en ce qu'**il comprend un dispositif d'identification (39) pour l'identification sans codeur de paramètres de circuit électrique équivalent (03, 05, 15) d'un moteur synchrone triphasé (09) selon l'une des revendications 7 à 10, les paramètres de circuit équivalent (03, 05, 15) identifiés pouvant être utilisés pour la détermination, l'optimisation et la surveillance du moteur (09) et/ou de la commande du moteur.

11. Dispositif selon la revendication 10, **caractérisé en ce qu'**il est conçu de façon telle qu'au moins lors de la première mise en service, de préférence plusieurs fois au cours de la durée de service, peut être effectuée une identification automatisée des paramètres de circuit équivalent (03, 05, 15) pendant un arrêt du rotor, une signalisation de défaut pouvant être déclenchée dans le cas d'un écart préréglable entre les paramètres de circuit équivalent (03, 05, 15) identifiés et des paramètres de circuit équivalent (03, 05, 15) préalablement déterminés, mémorisés et/ou modélisés.

12. Utilisation d'un procédé selon l'une des revendications de procédé précédentes pour la détermination, l'optimisation et la surveillance de paramètres d'un régulateur pour la commande d'entraînements électriques, en particulier pour le réglage de paramètres de régulation d'un dispositif de commande de moteur (35).

Fig. 1

Fig. 2

Fig. 3

Fig. 4

Fig. 5

EP 2 421 147 B1

Fig. 6

22

```
                    ┌──────────┐
                    │  Begin   │
                    └──────────┘
                         │
                         ▼
          ┌───────────────────────────────┐
          │  S1: Rotor-Fixposition (n=0)   │
          └───────────────────────────────┘
                         │
                         ▼
          ┌───────────────────────────────┐
          │   S2: PRBS-Stimulation         │
          │      in d-System               │
          └───────────────────────────────┘
                         │
                         ▼
          ┌───────────────────────────────┐
          │  S3: d/q in U/V/W-Conversion   │
          │      & Motor Stimulation       │
          └───────────────────────────────┘
                         │
                         ▼
          ┌───────────────────────────────┐
          │   S4: Monitoring u(n),i(n)     │
          └───────────────────────────────┘
                         │
                         ▼
          ┌───────────────────────────────┐
          │   S5: Fourier Transformation   │
          │    u(n),i(n)->u(k),i(k)        │
          └───────────────────────────────┘
                         │
                         ▼
          ┌───────────────────────────────┐
          │  S6: Parameter Extraction &    │
          │      System Identification     │
          │   G(k)=i(k)/u(k) -> R₁, L₁     │
          └───────────────────────────────┘
                         │
                         ▼
          ┌───────────────────────────────┐
          │  S7: Motorcontrol-Optimization │
          └───────────────────────────────┘
                         │
                         ▼
                    ┌──────────┐
                    │   End    │
                    └──────────┘
```

Fig. 7

Fig. 8

DSD-071
$P_N = 2.9$ kW
$n_N = 3000$ min$^{-1}$
$p = 4$
$I_N = 8.2$ A

— Gemessener Frequenzgang
— Exaktes Modell

Fig. 9a    f [Hz]

Baumüller DSD 071
$p = 4$
$I_n = 8.2$ A
$n_n = 3000$ min$^{-1}$
$P = 2.9$ kW

Fig. 9b    f [Hz]

Fig. 10a

Fig. 10b

## IN DER BESCHREIBUNG AUFGEFÜHRTE DOKUMENTE

**In der Beschreibung aufgeführte Patentdokumente**

- JP 2000032800 A

- US 20100060210 A1

**In der Beschreibung aufgeführte Nicht-Patentliteratur**

- Influence of the Power Density Spectrum of the Excitation Signal on the Identification of Drives. **VILLWOCK, S. et al.** INDUSTRIAL ELECTRONICS, 2008. IECON 2008. 34TH ANNUAL CONFERENCE OF IEEE. IEEE, 10. November 2008, 1252-1257
- Off-lIine identification of an open-loop automatic voltage regulator using pseudo-random binary sequence perturbations. **VERMEULEN, H.J. et al.** AFRICON, 1999 IEEE CAPE TOWN, SOUTH AFRICA. IEEE, 28. September 1999, vol. 2, 799-802

- **SEBASTIAN VILLWOCK.** Identifikationsmethoden für die automatisierte Inbetriebnahme und Zustandsüberwachung elektrischer Antriebe. *Dissertation,* 2007
- **S. VILLWOCK ; J. M. PACAS.** Application of the Welch-Method for the Identification of Two and Three Mass Systems. *IEEE Transactions on Industrial Electronics,* Januar 2008, vol. 55 (1), 457-466
- **P. SZCZUPAK ; J. M. PACAS.** Automatic Identification of a PMSM Drive Equipped with an Output LC-Filter. *IEEE Industrial Electronics, IECON 2006, 32nd Annual Conference,* November 2006, 1143-1148